(19) Europäisches Patentamt / European Patent Office / Office européen des brevets

(11) **EP 4 214 576 B1**

(12) **EUROPÄISCHE PATENTSCHRIFT**

(45) Veröffentlichungstag und Bekanntmachung des Hinweises auf die Patenterteilung:
**14.05.2025 Patentblatt 2025/20**

(21) Anmeldenummer: **21786082.4**

(22) Anmeldetag: **15.09.2021**

(51) Internationale Patentklassifikation (IPC):
**G03F 7/20** *(2006.01)*    **G03F 9/00** *(2006.01)*

(52) Gemeinsame Patentklassifikation (CPC):
**G03F 7/70383; G03F 7/70791; G03F 9/7088**

(86) Internationale Anmeldenummer:
**PCT/DE2021/100762**

(87) Internationale Veröffentlichungsnummer:
**WO 2022/057981 (24.03.2022 Gazette 2022/12)**

(54) **BELICHTUNGSSTEUERUNG BEI PHOTOLITHOGRAPHISCHEN DIREKTBELICHTUNGSVERFAHREN ZUR LEITERPLATTEN- ODER SCHALTKREISHERSTELLUNG**

EXPOSURE CONTROL IN PHOTOLITHOGRAPHIC DIRECT EXPOSURE METHODS FOR MANUFACTURING CIRCUIT BOARDS OR CIRCUITS

COMMANDE D'EXPOSITION DANS DES PROCÉDÉS D'EXPOSITION DIRECTE PHOTOLITHOGRAPHIQUES POUR LA FABRICATION DE CIRCUITS OU DE CARTES DE CIRCUIT IMPRIMÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.09.2020 DE 102020124006**

(43) Veröffentlichungstag der Anmeldung:
**26.07.2023 Patentblatt 2023/30**

(73) Patentinhaber: **Laser Imaging Systems GmbH 07745 Jena (DE)**

(72) Erfinder:
• **SCHWARZ, Christian**
  **07743 Jena (DE)**
• **BURGHOFF, Jonas**
  **99510 Apolda (DE)**
• **HEINEMANN, Stefan**
  **07745 Jena (DE)**
• **WAGNER, Holger**
  **07745 Jena (DE)**
• **RÜCKER, Steffen**
  **07751 Großlöbichau (DE)**
• **JUGEL, Frank**
  **99092 Erfurt (DE)**

(74) Vertreter: **FRKelly**
  **Waterways House**
  **Grand Canal Quay**
  **Dublin D02 PD39 (IE)**

(56) Entgegenhaltungen:
**DE-A1- 102017 102 320    US-A1- 2007 242 317
US-A1- 2012 327 215**

EP 4 214 576 B1

**Beschreibung**

Die Erfindung betrifft eine Vorrichtung zur Belichtungssteuerung bei photolithographischen Direktbelichtungsverfahren für zweidimensionale Strukturen in photoempfindlichen Beschichtungen, bevorzugt auf Leiterplatten, Displaysubstraten oder Wafern, sowie ein Verfahren zur Umsetzung von Registrierungsdaten in Direktbelichtungsdaten, insbesondere zur Anpassung der Registrierung an unebene Substrate und deren Umsetzung im Ergebnis einer Registrierung "On The Fly".

"On-The-Fly"-Registrierung bedeutet hier, dass die Positionsdaten von Zielmarken und somit die Lage des zu bearbeitenden Substrats und seiner Unebenheiten direkt während der kontinuierlichen Bewegung des Substrats sukzessive erfasst und für die Ausrichtung des Belichtungsmusters zum Substrat durch Anpassung der Belichtungsdaten für die unmittelbar folgende Direktbelichtung bereitgestellt werden.

Das Anwendungsgebiet der Erfindung liegt insbesondere in der Elektronikindustrie und in der Halbleiterindustrie bei der Leiterplatten-, Display- und Chipherstellung.

Aus dem Stand der Technik sind Belichtungssysteme für scheiben- oder plattenförmige Werkstücke bekannt, die ein Belichtungsobjekt durch elektromagnetische Strahlung, vorwiegend im sichtbaren oder ultravioletten Spektralbereich, mit einem Laserstrahl oder auch mit einem Elektronen- oder Partikelstahl mit einem vorbestimmten Muster belichten können. Dabei läuft die Belichtung erst ab, nachdem die richtige Lagebeziehung zwischen dem Belichtungsobjekt mit darauf befindlichen Markierungen (Zielmarken bzw. Targets) und einem in der Belichtungsvorrichtung hinterlegten vorbestimmten Muster hergestellt ist. Dazu werden die auf dem Belichtungsobjekt befindlichen Zielmarken durch eine oder mehrere Kameras erfasst und eine Ausrichtung von Belichtungsobjekt und Belichtungsmuster zueinander vor oder im Belichtungsbereich vorgenommen.

Für das Herstellen von Leiterbahnen oder kleinsten elektronischen Strukturen auf plattenförmigen Substraten, wie Leiterplatten, Displaysubstraten oder Wafern, sind die mit hoher räumlicher Präzision auszuführenden Belichtungsprozesse und die dafür erforderlichen Handhabungs- und Ausrichtungszeiten der plattenförmigen Werkstücke die begrenzenden Faktoren für die Steigerung des Durchsatzes. Deshalb wird angestrebt, die Handhabungs- und Belichtungsschritte überlappend oder zeitgleich auszuführen und bei gewünschter Belichtung von Vorder- und Rückseite in derselben Vorrichtung die Nebenzeiten des Belichtungsvorgangs zu verkürzen. Solche Lösungen sind beispielsweise in den Schriften EP 0 951 054 A1, EP 0 722 123 B1, US 6 806 945 B2 und JP 2010-181519 A offenbart.

Eine weitere Herausforderung bei den Direktbelichtungsverfahren besteht darin, die Registrierung unabhängig von der Art, Anzahl und Lage der Zielmarken (Targets) auf dem Belichtungsobjekt sowie von Höhenabweichungen der Objektoberfläche zu ermöglichen.

Eine Lösung zur Erfassung von Oberflächentopografien ist aus der WO 2016/115536 A2 bekannt, bei der ein bekanntes zweidimensionales Muster, auf die Oberfläche projiziert oder anderweitig aufgebracht, zusammen mit der Oberfläche zweidimensional aufgenommen und anhand der Verzerrung des Musters durch Unebenheiten der Oberfläche die dreidimensionale Form der Oberfläche ermittelt wird. Aufgrund der begrenzten Auflösung ist dieses Verfahren jedoch ungeeignet zum Erfassen wenig differenzierter Unebenheiten.

Die EP 0 954 768 B1 beschreibt eine Vorrichtung zum Fokussieren auf Oberflächen eines Halbleiter-Wafers, bei der für einen Halbleiter-Wafer vor dem Belichten in einer Belichtungsanlage die reale Oberflächentopografie aufgenommen wird. Dazu wird die Oberfläche mit einem Abstandssensor flächig als Höheninformationen erfasst und anschließend periodische Höhenschwankungen ermittelt und diese gespeichert. Anhand der ermittelten periodischen Höhenschwankungen wird für zu belichtende Teilbereiche der Wafer-Oberfläche eine optimierte Fokusposition für die Belichtungsoptik ermittelt und der Wafer entsprechend ausgerichtet. Nachteilig ist die zeitaufwändige Erfassung der Höheninformation mittels des Abstandssensors sowie die anschließende Ausrichtung des Wafers.

Eine weitere Registrierungssteuerung für das Belichten von Substraten, insbesondere beim Laser-Direkt-Belichten an Multilayer-PCB's (Printed Circuit Boards), offenbart die WO 03/094582 A2, bei der ein digitales Steuerungsbild durch ungleichförmiges Modifizieren einer Darstellung des elektrischen Schaltkreises derart erzeugt wird, dass ein elektrisches Schaltungsmuster, das auf einem Substrat durch Nutzung des digitalen Steuerungsbildes aufgeprägt ist, exakt zu einem bereits vorhandenen Schaltkreisteil passt. Dazu erfolgt die Registrierung ausgewählter Referenzmarken an einer vorhandenen Ist-Struktur, wobei anhand von Abweichungen zwischen Ist- und Soll-Positionen in den Raumrichtungen die zu belichtende Soll-Struktur korrigiert wird, sodass die Belichtung mit einem modifizierten Abtastraster erfolgt. Da zur Registrierung eine im Belichtungskopf vorhandene Kamera genutzt wird, muss jede Referenzmarke nachteilig durch Relativbewegung zwischen Substrat und Abtastkopf angefahren werden.

Aus der DE 10 2018 132 001 A1 ist eine Vorrichtung zum Bearbeiten von plattenförmigen Werkstücken mit hohem Werkstückdurchsatz zur Verwendung in der Direktbelichtung von Leiterplatten bekannt, bei der zur Zielmarkenerfassung bei auf der Leiterplatte vorbekannter Lage der Zielmarkenpositionen die Registriereinheit mit zwei bis drei lateral zur Leiterplattenbewegung verschiebbaren Flächenkameras ausgestattet ist, wobei die Kameras in Parallelstellung zu einem Bearbeitungspfad alternierend für Registrierung von Leiterplatten mit zwei auf demselben Schienensystem bewegten Tischen in Parallelstellung zu einem Bearbeitungspfad angeordnet sind, um die Taktzeiten für die Bearbeitung der Leiterplatten durch Verkürzung der Handhabungs- und Nebenzeiten zu minimieren. Die Kameras sind dabei regelmäßig über den Randbereichen der Leiterplatten oder Schaltkreise eines Leiterplattennutzens angeordnet, in denen die Zielmarken bekanntermaßen zu erwarten sind. Die Erfassung von beliebig positionierten Zielmarken, die bei Leiterplatten und Wafern zunehmend notwendig werden, sind wegen erforderlicher Kameraverschiebungen nur mit verschlechtertem Durchsatz möglich und Höhenschwankungen der Substratoberfläche können gar nicht erfasst werden.

In der EP 2 775 349 A1 ist ein Verfahren zum Ermitteln einer korrekten Fokus-Position in einem optischen Inspektionssystem beschrieben, bei dem eine Differenz zwischen der Fokuslage des Inspektionssystems und der Lage eines zu inspizierenden Gegenstands ermittelt wird, wobei unabhängig von der korrekten Fokus-Position ein Bild des Gegenstands aufgenommen wird. Ein Algorithmus des Inspektionssystems kann anhand von Merkmalen des aufgenommenen Bildes auf die Größe der Differenz und Richtung der Abweichung zwischen der Fokuslage und der Lage des Gegenstands schließen, indem die Lage des Gegenstands an die Fokuslage des Inspektionssystems entsprechend der Differenz und der Richtung angepasst wird. Bei dem Verfahren, das für eine zu mikroskopierende Probe beschrieben ist, in der verschiedene charakteristische Objekte, die unterschiedliche räumliche Ausdehnung und somit in der beobachteten Fläche erhebliche Höhenunterschiede aufweisen können, aufgefunden werden sollen, ist eine singuläre Anpassung der Fokuslage erforderlich, um die verschiedenen Objekte deutlich erfassen zu können. Eine Erfassung des Höhenprofils in der gesamten Fläche ist dabei nicht vorgesehen.

Die Patentschriften US 6 245 585 B1 und US 6 449 029 B1 beschreiben Verfahren und Vorrichtungen zur Anpassung der Fokuslage bei der Photolithographie eines Halbleiter-Wafers. Vor der Belichtung wird in jedem einzelnen zu belichtenden Teilabschnitt des Wafers die Höhe der Oberfläche in z-Richtung gemessen. Die Teilabschnitte sind rasterartig angeordnete Rechtecke, die nacheinander belichtet werden, wobei an der Oberfläche eines jeden Teilabschnitts die Reflexionen von fünf schräg einfallenden Laserstrahlen, von denen einer auf das Zentrum und vier auf jeweils eine der Ecken des Teilbereichs gerichtet sind, erfasst werden. Aus der Lage der Reflexionen können Offset-Werte, mit denen die Höhenlage jedes Teilbereichs von einer Referenzhöhe abweicht, ermittelt und ein Oberflächenwinkel für jeden Teilabschnitt berechnet werden. Vor der Belichtung eines jeden Teilabschnitts erfolgt dann eine Ausrichtung des Wafers entsprechend den gespeicherten Werten, wobei die Ausrichtung mittels individuell ansteuerbaren Aktuatoren erfolgt, mit denen Höhe und Winkel angepasst werden. Für den jeweiligen Teilbereich ist dabei aber lediglich eine gemittelte Korrektur über den gesamten Teilbereich einstellbar.

In der nicht vorveröffentlichten DE 10 2019 128 198.9 wird eine Vorrichtung zur Mustereinbringung mittels Strahlung an einem aufgewickelten Endlossubstrat beschrieben, bei der die Zielmarkenregistrierung und die Musterbelichtung auf einem an einer Bearbeitungstrommel straff geführten Endlossubstrat erfolgt. Liegen sich Registriereinheit und Bearbeitungseinheit an der Trommel diametral gegenüber, kann durch Bewegung der Trommel longitudinal zur Substratbewegungsrichtung eine Höhenänderung des Substrats aufgrund der Trommelkrümmung zur Anpassung sowohl der Fokussierung der Kameras der Registriereinheit als auch des Bearbeitungsstrahls genutzt werden. Eine Messung der Größe der Defokussierung erfordert jedoch weitere Hilfsmittel, mit denen die absolute Lage der Substratoberfläche ermittelt werden kann.

Die US 2004/0223129 A1 offenbart eine Belichtungseinrichtung zum flächigen Belichten von photoempfindlichem Material, das in einer Ebene relativ zu einer Belichtungseinrichtung bewegt wird, die mehrere gleichartige, in einer Matrix angeordnete Belichtungsköpfe aufweist. In jedem der Belichtungsköpfe wird das Licht einer Lichtquelle zu einem zweidimensionalen Muster moduliert, das zum Belichten mittels einer telezentrischen Optik auf die Materialoberfläche projiziert wird. Zum Ausgleich von Unebenheiten an den verschiedenen Stellen der Materialoberfläche verfügt jeder Belichtungskopf im Strahlengang über ein Paar von Keilprismen, mit denen die optische Länge zwischen dem Objektiv und der Materialoberfläche angepasst wird, wenn Abstandssensoren auf Basis reflektierter Laserstrahlung Unebenheiten aufgrund eines geänderten Ortes der Materialoberfläche erkannt haben. Nachteilig ist dabei die Einzelnachführung für jeden Belichtungskopf und dessen Bildfeld als einzelnes Bildsegment, was zu sprunghaften Änderungen des Abbildungsmaßstabs in benachbarten Bildsegmenten führen kann.

Der Erfindung liegt die Aufgabe zugrunde, eine neue Möglichkeit zur verbesserten Belichtungssteuerung bei Direktbelichtungsverfahren für zweidimensionale Strukturen in photoempfindlichen Schichten auf Leiterplatten oder Wafern zu finden, die eine Registrierung von Zielmarken "On The Fly" unabhängig von definierten Orten der Zielmarken gestattet sowie den Einsatz von teuren telezentrischen Objektiven vermeidet. Eine erweiterte Aufgabe besteht darin, eine flexible Anpassung des Belichtungsmusters auch für festgestellte Unebenheiten des Substrats zu erreichen.

Die DE 10 2017 102 320 A1 offenbart eine Bearbeitungsanlage, insbesondere eine optische Bearbeitungsanlage, für einen Substratkörper, umfassend ein Belichtungssystem mit einer Belichtungseinheit oder mehreren Belichtungseinheiten, ein Kalibriersystem mit mindestens einer Kalibrierkamera zur Justierung des Belichtungssystems, eine Substratträgereinheit mit einer Haltevorrichtung für den Substratkörper und ein Registriersystem mit einer Registrierkamera oder mehreren Registrierkameras, wobei eine Lage und/oder Ausrichtung des von der Haltevorrichtung gehaltenen Substratkörpers in zumindest einer Registrierposition der Substratträgereinheit von der einen oder von zumindest einer Registrierkamera erfassbar ist, so auszubilden, dass das Belichtungssystem und das Registriersystem in einfacher Weise aufeinander abstimmbar sind, wird vorgeschlagen, dass das Kalibriersystem eine Referenzmarkierung oder mehrere Referenzmarkierungen aufweist, welche jeweils in einer definierten Relativposition zu der mindestens einen Kalibrierkamera angeordnet sind, und dass die eine oder mindestens eine Referenzmarkierung von der einen oder mindestens einer Registrierkamera erfassbar ist.

Die US 2007/242317 A1 offenbart eine zu DE 10 2017 102 320 A1 ähnliche Belichtungsanlage.

Die US 2012/327215 A1 offenbart einen optischen Inspektionssensor. Der Sensor umfasst eine Kameraanordnung, die dazu konfiguriert ist, Bilddaten relativ zu einem Werkstück zu erfassen, das sich ununterbrochen relativ zur Kameraanordnung bewegt. Ein Beleuchtungssystem ist so angeordnet, dass es einen Beleuchtungsimpuls liefert, wenn die Kameraanordnung die Bilddaten erfasst.

Erfindungsgemäß wird die Aufgabe in einer Vorrichtung zur Belichtungssteuerung bei photolithographischer Direktbelichtung von zweidimensionalen Strukturen in photoempfindlichen Beschichtungen auf einem Substrat, enthaltend eine Registriereinheit zum Registrieren von auf einer Substratoberfläche befindlichen Zielmarken, ein bewegliches Tischsystem zur Auflage und definierten eindimensionalen Bewegung des Substrats unterhalb der Registriereinheit, eine Bearbeitungseinheit mit einem steuerbaren linearen Bearbeitungspfad zur photolithographischen Bearbeitung des Substrats mittels eines Bearbeitungsstrahls zur Einprägung der zweidimensionalen Strukturen sowie eine Rechnereinheit zur Steuerung der Ausrichtung zwischen Bearbeitungspfad und Substrat mittels örtlicher Anpassung der photolithographischen Bearbeitung in Abhängigkeit von der durch registrierte Zielmarken ermittelten Lage des Substrats, dadurch gelöst, dass in der Registriereinheit mehrere entozentrische Kameras zur Ausbildung eines lückenlosen linearen Abtastbereichs über eine vorgegebene Breite des Substrats in linearer Ausrichtung quer zur eindimensionalen Bewegung des Substrats angeordnet sind und in Richtung des linearen Abtastbereichs ausgedehnte Bildwinkel aufweisen, wobei die Bildwinkel benachbarter entozentrischer

Kameras entlang des linearen Abtastbereichs einen Überlappungsbereich haben, um im Überlappungsbereich redundante Bildaufnahmen des Substrats der benachbarten Kameras zu erfassen, und dass die Rechnereinheit Mittel zur Berechnung der Position der Zielmarken aus den redundanten Bildaufnahmen im Überlappungsbereich (13) der benachbarten entozentrischen Kameras unter zusätzlicher Verwendung einer durch Triangulation eines Abstandes der Substratoberfläche ermittelten Höhenposition der Zielmarken aufweist.

Vorteilhaft ist die Registriereinheit mit einer Mehrzahl von entozentrischen Kameras zur Erzeugung des linear durchgehenden lückenlosen Sensorbereichs derart ausgestattet ist, dass Bildwinkel von benachbarten Kameras einen Überlappungsbereich aufweisen, der mindestens so groß wie der halbe Bildwinkel ist, wobei die Rechnereinheit derart eingerichtet ist, um beliebig über die Breite des Substrats positionierte Zielmarken unabhängig von der Position der Zielmarke innerhalb von lückenlos aufeinanderfolgenden Überlappungsbereichen der Bildwinkel von jeweils benachbarten entozentrischen Kamera durch Triangulation eines Abstandes an beliebigen Positionen der Substratoberfläche zu ermitteln.

Die Kameras sind vorzugsweise Zeilenkameras, um den linienförmigen Abtastbereich durch Kameras mit großer Abtastlänge schmal, lückenlos und mit Überlappungsbereichen über die gesamte Breite des Substrats auszubilden.

Zweckmäßig sind die Kameras mit zueinander parallelen optischen Achsen auf die Substratoberfläche gerichtet, wobei die Überlappungsbereiche der Bildwinkel aller Kameras gleich groß sind.

In einer anderen vorteilhaften Ausführung zwei benachbarte Kameras mit zueinander geneigten optischen Achsen auf die Substratoberfläche gerichtet, wobei der Überlappungsbereich der Bildwinkel der zueinander geneigten Kameras so eingestellt ist, dass die Bildwinkel der zwei Kameras auf der Substratoberfläche vollständig überlappen.

Dabei ist der Überlappungsbereich, der durch paarweise zueinander geneigte Kameras gebildet wird, mindestens an einen weiteren Überlappungsbereich lückenlos angeschlossen, bis die Überlappungsbereiche eine Ausdehnung aufweisen, die mindestens der Breite des Substrats entspricht, wobei zwischen Paaren von zueinander geneigten Kameras eine Überlappung vorgesehen sein kann, um für alle zulässigen Höhenschwankungen $\Delta z$ der Substratoberfläche einen lückenlosen Abtastbereich der Registriereinheit zu garantieren.

Vorzugsweise sind die paarweise mit zueinander geneigten Kameras so angeordnet, dass sie einer Scheimpflug-Bedingung unterliegen.

In einer vorteilhaften Ausführung der Erfindung weist die Rechnereinheit zusätzlich eine Steuerung für eine schnelle Fokusnachführung der Bearbeitungseinheit entlang des Bearbeitungspfades in Abhängigkeit von Höhenschwankungen $\Delta z$ der Substratoberfläche auf, die eine Triangulation von Zielmarken oder beliebigen abgebildeten Strukturen der Substratoberfläche auf Basis der redundanten Bildaufnahmen im Überlappungsbereich der benachbarten entozentrischen Kameras beinhaltet.

In einer weiteren bevorzugten Variante weist die Registriereinheit für die Zielmarkenerfassung lediglich zwei auf einer Abtastlinie (quer zur Bewegungsrichtung des Substrats angeordnete entozentrische Kameras mit einem Überlappungsbereich von einem Hundertstel bis einem Drittel des Bildwinkels der Kamera auf, wenn das Substrat als flexibles Endlossubstrat auf einem Rollentischsystem straff und ohne Höhenschwankungen $\Delta z$ geführt ist, wobei der Überlappungsbereich der Bildwinkel der zwei Kameras so ausgelegt ist, dass die Triangulation zum Zwecke der genauen Ermittlung der Dicke des Substrats im Überlappungsbereich der Bildwinkel auf dem Rollentischsystem anwendbar ist und für die gesamte Breite des Rollentischsystems als konstant angenommen werden kann.

Des Weiteren ist die Registriereinheit zweckmäßig mit Lichtquellen zur Beleuchtung des linearen lückenlosen Abtastbereichs ausgestattet, die im Gehäuse gleichmäßig verteilt zur Realisierung einer durch Dunkelfeld- oder Hellfeldbeleuchtung homogen beleuchteten Abtastlinie angeordnet sind.

Dabei sind die Lichtquellen für eine ständige Beleuchtung eingerichtet und verfügen über eine Einrichtung zur Steuerung von mindestens einer Eigenschaft aus Helligkeit, Einfallswinkel oder Spektralbereich.

Außerdem können die Lichtquellen für eine ständige Beleuchtung eingerichtet sein, um Bildaufnahmen durch Steuerung der Integrationszeit der Sensorzeile mittels eines elektronischen Shutter-Prinzips zu ermöglichen.

In einer weiteren bevorzugten Ausführung der Erfindung ist eine Fokusnachführung für Höhenschwankungen $\Delta z$ des Substrats in die Bearbeitungseinheit integriert, mit der von der Rechnereinheit mittels Triangulation aus mit zwei benachbarten Kameras der Registriereinheit redundant aufgenommen Bildern ermittelte Höhenschwankungen $\Delta z$ durch schnelle Fokuskorrektur je Bildpunkt der Registriereinheit in Echtzeit anpassbar sind, wobei die Fokusnachführung auf Basis von Änderungen einer Linsen- oder Spiegelposition oder -wölbung steuerbar ist.

Dabei ist die Fokusnachführung vorteilhaft auf Basis der Änderung einer Spiegelwölbung mindestens in Querrichtung x zur Bewegungsrichtung y des Substrats steuerbar. Die Fokusnachführung kann bevorzugt auf Basis von Änderungen einer Spiegelwölbung in Bewegungsrichtung y des Substrats und einer Spiegelwölbung in Querrichtung x separat steuerbar sein.

In einer zweckmäßigen Ausführung ist die Fokusnachführung durch Änderung der Spiegelwölbung mittels eines Piezoelements steuerbar.

Vorteilhafterweise kann die Fokusnachführung auf Basis von Änderungen einer Linsen- oder Spiegelposition oder -wölbung ebenfalls zur Korrektur von aus dem Optikdesign oder der Optikfertigung resultierender abbildungsbedingter Fokusabweichungen einer vorgelagerten Fokussieroptik oder anderer vorgelagerter optischer Elemente angewendet werden.

Die Aufgabe wird des Weiteren gelöst bei einem Verfahren zur Belichtungssteuerung bei photolithographischen Direktbelichtung von zweidimensionalen Strukturen in photoempfindlichen Beschichtungen auf einem Substrat, mit den folgenden Schritten:

- Anordnen mehrerer entozentrischer Kameras zu einem lückenlosen linearen Abtastbereich quer zu einer Bewegungsrichtung des Substrats in einer Registriereinheit zum Erfassen von auf dem Substrat befindlichen Zielmarken, wobei die entozentrischen Kameras entlang des linearen Abtastbereichs ausgedehnte Bildwinkel mit einem von benachbarten entozentrischen Kameras gebildeten Überlappungsbereich aufweisen, um im Überlappungsbereich redundante Bildaufnahmen des Substrats aus benachbarten Kameras zu erhalten,
- Bewegen des Substrats auf einem beweglichen Tischsystem in einer definierten eindimensionalen Bewegung unterhalb der Registriereinheit hindurch,
- Bereitstellen einer Bearbeitungseinheit zur photolithographischen Erzeugung der zweidimensionalen Strukturen mit einem Bearbeitungsstrahl, der entlang eines linearen Bearbeitungspfades steuerbar ist,
- Erfassen der räumlichen Lage von beliebig über eine vorgegebene Breite des Substrats verteilten Zielmarken bezüglich Längen-, Breiten- und einer Höhenposition bei einem einzigen Durchlauf des Substrats durch den linearen Abtastbereich der Registriereinheit,
- Ermitteln der Positionen der beliebig über die Breite des Substrats verteilten Zielmarken aus den redundanten Bildaufnahmen im Überlappungsbereich der benachbarten entozentrischen Kameras unter zusätzlicher Verwendung einer durch Triangulation eines Abstandes der Substratoberfläche aus den redundanten Bildaufnahmen benachbarter entozentrischer Kameras ermittelten Höhenposition der Zielmarken,
- Berechnen von Daten zur Ausrichtung und örtlichen Anpassung der Bearbeitung des Substrats mit zweidimensionalen Strukturen für die Bearbeitungseinheit zur Steuerung des Bearbeitungsstrahls entlang des quer zur Bewegungsrichtung des Substrats ausgerichteten, linearen Bearbeitungspfades, und
- Steuern der Ausrichtung zwischen Bearbeitungspfad und Substrat und örtliche Anpassung der photolithographischen Bearbeitung in Abhängigkeit von der durch registrierte Zielmarken ermittelten Lage des Substrats.

In einer bevorzugten Verfahrensvariante wird das Berechnen der räumlichen Lage von beliebig über die Breite des Substrats verteilten Zielmarken auf Basis einer Höhenposition bei einem Durchlauf des Substrats auf die Triangulation weiterer erfassbarer Strukturen des Substrats in den im Überlappungsbereich aufgenommenen redundanten Bildern erweitert und es erfolgt eine schnelle Fokusanpassung des Fokus des Bearbeitungsstrahles mittels einer Fokusnachführung entlang eines Bearbeitungspfades auf Basis einer Steuerung einer Linsen- oder Spiegelposition oder einer Spiegelwölbung.

Dabei erfolgt die schnelle Fokusanpassung des Fokus des Bearbeitungsstrahles vorteilhaft mit einer mindestens zweifach bis dreißigfach höheren Frequenz als die herkömmliche Scanfrequenz für den Bearbeitungsstrahl.

Die Erfindung basiert auf der Grundüberlegung, dass für die sogenannten Registriersysteme eine oder mehrere Kameras mit zweidimensionalen Sensoren (z.B. CCD-Kameras, CMOS-Kameras) zum Einsatz kommen, die üblicherweise mit telezentrischen Objektiven ausgestattet und genau senkrecht über definierten Abschnitten Substraten angeordnet sind. Dadurch bleiben innerhalb der verfügbaren Schärfentiefe von telezentrischen Kameras die detektierten Positionen konstant, auch wenn sich die Fokuslage des Objektivs gegenüber dem Substrat infolge von Dickenoder Topografieänderungen verschiebt. Bauartbedingt sind telezentrische Objektive vergleichsweise teuer und derart voluminös, dass die mechanische Ausdehnung eines Objektivs stets größer als das aufzunehmende Bildfeld sein muss. Telezentrische Objektive erlauben deshalb keine lückenlosen Bildaufnahmen durch mehrere entlang einer Geraden positionierte Kameras, sondern müssten dafür versetzt entlang mehrerer paralleler Linien angeordnet sein. Außerdem ist eine inhärente Ermittlung von Höhenabweichungen des Substrats, die für die hochgenaue Ermittlung der Zielmarkenposition sowie für die genaue Ausrichtung und Anpassung des Belichtungsmusters wesentliche Bedeutung erlangt, nicht möglich.

Die Erfindung löst diese Probleme durch eine Kombination aus einer Art linienförmiger Bildabtastung über die gesamte Substratbreite (nachfolgend: FPSS - engl.: Full Panel Scan System) bei einer fortschreitenden Relativbewegung zwischen Substrat und linienförmigem Abtastbereich durch Kameras mit entozentrischen Objektiven, deren Bildwinkel sich so weit überlappen, dass eine Triangulation von Höhenunterschieden aus mehreren Kamerabildern unterschiedlicher Kameras für jede Substratposition des linearen Abtastbereichs möglich ist, oder aber durch eine definierte Mehrkameraanordnung mit schräg zum Substrat positionierten Kameras, die unter Einhaltung einer Scheimpflug-Bedingung eine vollständige Überlappung der Bildwinkel zweier benachbarter Kameras und somit eine Triangulation für jede Substratposition des linearen Abtastbereichs aus nur zwei Kamerabildern erlaubt.

Unter Bildwinkel im Sinne der vorliegenden Erfindung werden Definitionen aus dem Fachgebiet der Fotografie verwendet. Dabei wird der Bildwinkel als derjenige Winkel im Objektraum (Gegenstandsraum) verstanden, der durch die Ränder des Aufnahmeformats einer Kamera (hier Kamera der Registriereinheit) begrenzt ist Demzufolge wird hier der Bildwinkel jeweils durch die Höhe und die Breite des Aufnahmeformats bestimmt (im Unterschied zur häufig auch verwendeten Diagonale, die den maximalen Bildwinkel unabhängig vom tatsächlich verwendeten Seitenverhältnis des Aufnahmeformats angibt). Das Aufnahmeformat ist durch das Sensorformat vorgegeben, wodurch ein objektseitiges Sichtfeld (engl. field of view - FOV) über die Objektivabbildung als derjenige Objektraum definiert ist, der durch den horizontalen und den vertikalen Bildwinkel aufgespannt wird.

Außer durch das Bildformat - Höhe H und Breite B des Aufnahmeformats - werden die Bildwinkel im Wesentlichen nur noch durch die aktuelle Brennweite $f$ des Objektivs bestimmt. Die Brennweite $f$ kann allerdings nur bei Einstellung des Objektivs auf "unendlich" (objektseitig telezentrisches Objektiv) direkt zur Definition der Bildwinkel verwendet werden. Bei Abbildungen von Objekten in einer endlichen Gegenstandsweite (kurzen Objektentfernung) wird die Bildweite $b$ größer als die Brennweite $f$ und ersetzt diese, wodurch sich für die Breite B des Aufnahmeformats der horizontale Bildwinkel zu

$$\alpha = 2 \cdot \arctan [\mathrm{B}/(2 \cdot b)] \qquad (1).$$

ergibt.

Bei Verwendung von Zeilenkameras ist der horizontale Bildwinkel gemäß Gleichung (1) der maßgebliche Bildwinkel der Kamera aufgrund des nahezu linearen Sensorformats und kann deshalb allein zur Definition des linearen objektseitigen Sichtfeldes (FOV) benutzt werden.

Die durch lokale Triangulation ermittelten Höhenabweichungen des Substrats entlang einer Abtastlinie mit entozentrischen Kameras sind außer für die genaue zweidimensionale Registrierung von Zielmarken auch zusätzlich für eine punktgenaue Nachführung der Fokuslage des linienförmig entlang eines Bearbeitungspfades bewegten Bearbeitungsstrahls verwendbar. Die Nachführung des Bearbeitungsstrahls entlang des Bearbeitungspfades zur üblichen Ausrichtung des Belichtungsmusters an die registrierten Zielmarkenpositionen kann aufgrund der erfassten Höhenschwankungen zusätzlich durch Stellmechanismen zur schnellen Fokusänderung des Bearbeitungsstrahls ergänzt werden, wobei die Fokusänderung mindestens mit der doppelten bis zehnfachen Frequenz der üblichen Scanfrequenz des Bearbeitungsstrahls (bei Polygonscannern zwischen 0,5 und 1 kHz) vorgenommen werden und deshalb mittels einfacher linearer Positionsänderungen oder Änderung von Krümmungsradien von Linsen oder Spiegeln steuerbar sein muss.

Durch die Erfindung wird eine neue Möglichkeit zur verbesserten Belichtungssteuerung bei Direktbelichtungsverfahren für zweidimensionale Strukturen in photoempfindlichen Schichten auf Leiterplatten oder Wafern realisiert, die eine Registrierung von Zielmarken "On The Fly" mittels eines linearen Abtastbereichs unabhängig von festen Ortsvorgaben der Zielmarken für definierte Belichtungsfelder gestattet und den Einsatz von teuren telezentrischen Objektiven vermeidet sowie eine flexible Ausrichtung und Anpassung des Belichtungsmusters auch für festgestellte Unebenheiten des Substrats ermöglicht.

Die Erfindung wird nachfolgend anhand von Ausführungsbeispielen und Abbildungen näher erläutert. Dabei zeigen:

Fig. 1:   eine schematische Darstellung einer Registriereinheit zur Zielmarkenerfassung, ausgebildet als eine Mehrkamerakonfiguration, die eine lineare Anordnung von entozentrischen Kameras mit überlappenden Bildbereichen zur Erreichung eines linienförmigen Abtastbereiches über die vollständige Objektbreite quer zur Objektbewegung beinhaltet;

Fig. 2:   eine schematische Darstellung der Registriereinheit, ausgebildet als eine Mehrkamerakonfiguration, bei der die lineare Anordnung der Kameras mit paarweise gegeneinander geneigten entozentrischen Kameras, die einer Scheimpflug-Bedingung genügen und paarweise einen vollständig überlappenden Bildbereich aufweisen, ausgebildet ist;

Fig. 3:   eine schematische Darstellung zur Realisierung der Ausrichtung einer entozentrischen Kamera unter Scheimpflug-Bedingungen;

Fig. 4:   eine schematische perspektivische Darstellung von zwei ausgewählten zeitlich nacheinander ausgeführten Linienabtastungen der Registriereinheit sowie eine Ergebnisdarstellung der Höhenvariation des Objekts entlang zweier ausgewählter Linienabtastungen;

Fig. 5:   eine schematische Darstellung der zur Höhenmessung verwendeten Triangulationsmethode im Überlappungsbereich von zwei benachbarten entozentrischen Kameras;

Fig. 6:   eine schematische Darstellung der Erfindung in einer Seitenansicht quer zur Objektbewegungsrichtung mit vergrößert dargestellter Höhenschwankung der Substratoberfläche, wobei die Registriereinheit schematisch über eine Rechnereinheit mit der Bearbeitungseinheit verbunden ist zur Umsetzung der durch Triangulation erfolgten Höhenmessung in eine punktgenaue Steuerung der Fokussierung innerhalb des orthogonal zur Zeichnungsebene gescannten Bearbeitungsstrahls;

Fig. 7:   eine schematische perspektivische Darstellung der Erfindung mit Registriereinheit und Bearbeitungseinheit quer zur Substratbewegungsrichtung an einem Endlossubstrat, das an einem Rollentischsystem straff geführt ist;

Fig. 8:   eine schematische Darstellung zur Realisierung der Fokussierungssteuerung zur aktuellen Fokusnachführung mittels einer beweglichen Objektivlinse;

Fig. 9:   eine schematische Darstellung zur Realisierung der Fokussierungssteuerung zur aktuellen Fokusnachführung mittels eines festen Winkelspiegels und eines beweglichen Retroreflektors;

Fig. 10:   eine perspektivische Darstellung der Realisierung eines elastisch biegbaren Spiegelelements, das mit einem Linearaktuator die Spiegelwölbung ändert;

Fig. 11   :eine schematische Darstellung des biegbaren Spiegelelements von Fig. 10;

Fig. 12:   eine schematische Darstellung zur Realisierung der Fokusnachführung mit je einem elastischen Spiegelelement nach Fig. 10 für die Spiegelsteuerung separat in Bewegungsrichtung und in Querrichtung des Substrats.

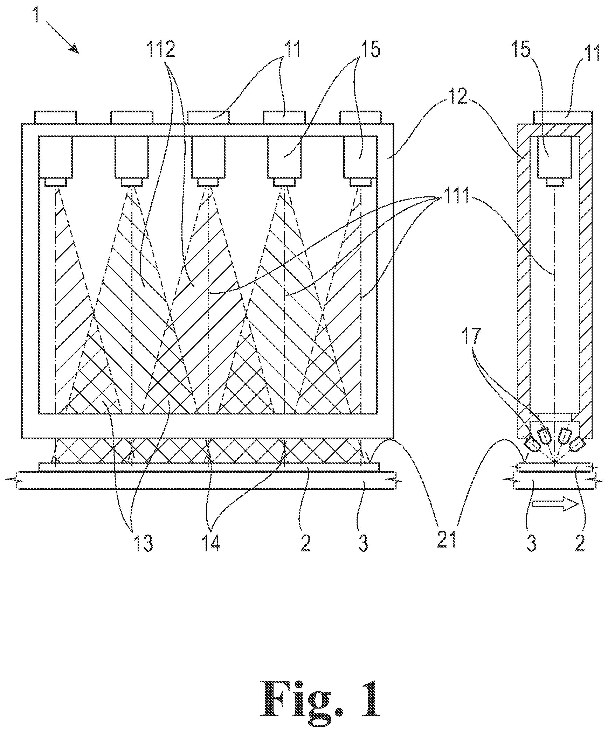

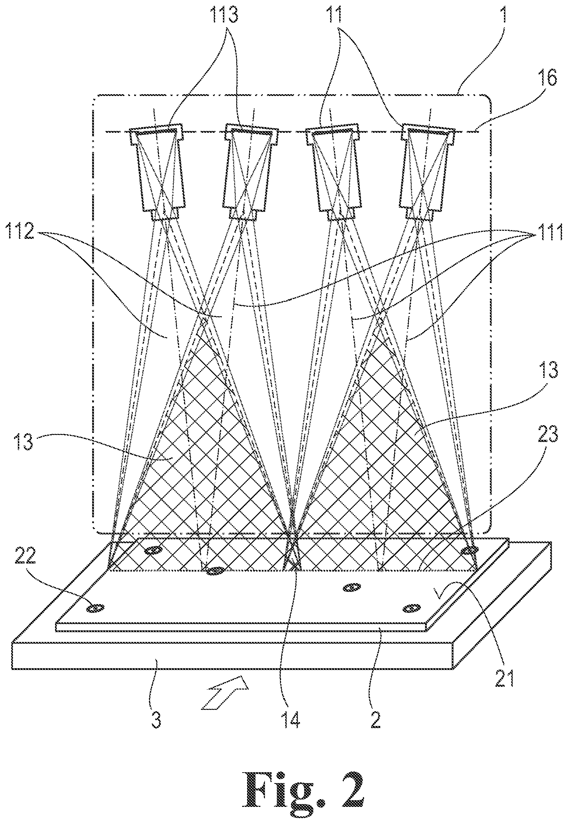

Die erfindungsgemäße Registriereinheit 1 enthält in einer vorteilhaften Grundvariante gemäß Fig. 1 eine Mehrzahl von Kameras 11, die eine lineare Konfiguration so ausbilden, dass deren optische Achsen 111 innerhalb der Ebene des Substrats 2 auf eine Linie (Abtastlinie 23 - nur in Fig. 2, Fig. 4 und Fig. 6 dargestellt) quer zur Bewegungsrichtung des vorbeigeführten Substrats 2 gerichtet sind und die durchfahrende Substratbreite vollständig durch einander teilweise überlappende Bildwinkel 112 bzw. linienförmig ausgebildete Sichtfelder (Fields of View - FOV) der Kameras 11 abgedeckt ist. Dies ist aufgrund nicht telezentrischer, sondern entozentrischer Objektive 15 möglich, wobei die Kameras 11 außerdem als Zeilenkameras mit einer oder wenigen parallel angeordneten Sensorzeilen 114 ausgerüstet sind.

Der Aufbau aus Kameras 11 mit einzelnen Sensorzeilen 114 (sog. Zeilenkameras, in Fig. 1 nicht dargestellt) ist skalierbar, d.h. durch Kombination mehrerer Kameras 11 kann jede erforderliche Abtastbreite erreicht werden. Da nur in dem Überlappungsbereich 13 der Bildwinkel 112 zweier Kameras 11 die genaue Position von Zielmarken 22 ermittelt werden kann, gehen Bereiche ohne Überlappung für eine exakte Messung verloren, sodass die Bildwinkel 112 der Kameras 11 in den Randbereichen des Substrats 2 - sofern die Überlappungsbereiche 13 auf den halben Bildwinkel 112 beschränkt sind - nur zur Hälfte genutzt werden können. Für die Kameras 11 im Randbereich des Substrats 2 ist deshalb in Fig. 1 nur der halbe Bildwinkel 112 eingezeichnet.

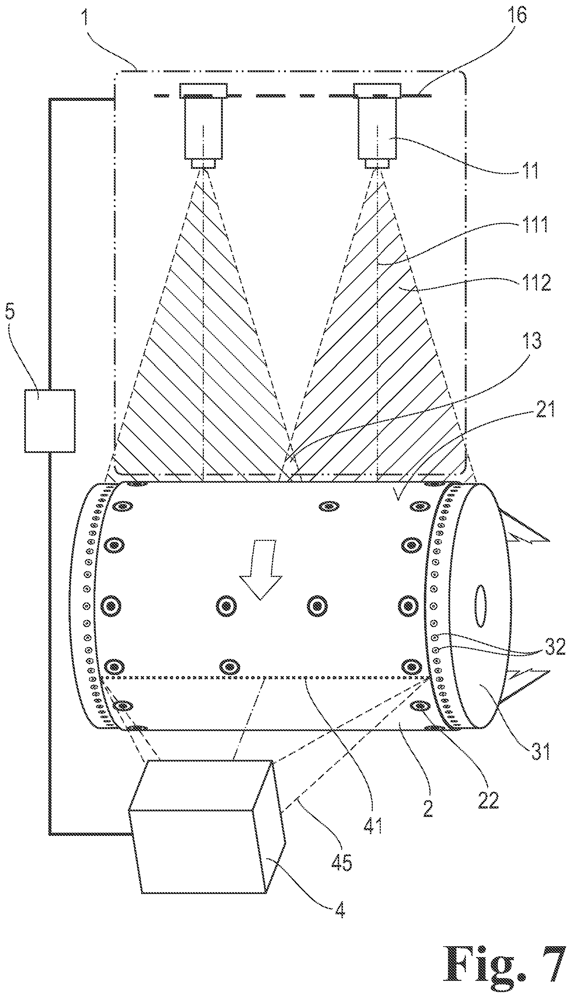

Die Registriereinheit 1 ist mit ihrem lang gestreckten Gehäuse 12 quer zur Bewegungsrichtung des auf Zielmarken 22 (nur in Fig. 2 und Fig. 7 eingezeichnet) abzutastenden Substrats 2 ausgerichtet, wobei das Substrat 2 zweckmäßig auf einem Tischsystem 3 (nur als Auflageoberfläche dargestellt) darunter hindurchgeführt wird. Wie in der Seitenansicht von Fig. 1 erkennbar, weist die Registriereinheit 1 in einem geringen Abstand zur Substratoberfläche 21 intensive Beleuchtungsmittel auf, die als Lichtquellen 17 so angebracht sind, dass deren Beleuchtungslicht nur das Substrat 2 beleuchtet, ohne direktes Licht in Richtung der Kameras 11 abzugeben und die Beleuchtung unter verschiedenen schrägen Einfallswinkeln (Dunkelfeldbeleuchtung) und ggf. mit unterschiedliche Spektralfarben erfolgen kann. Alternativ ist es aber auch möglich, dass das Licht der Lichtquellen 17 als Hellfeldbeleuchtung (nicht gezeichnet) direkt in den Aufnahmestrahlengang der Kameras 11 eingekoppelt wird.

Die in Fig. 1 gewählte Kamerakonfiguration besteht aus fünf Kameras 11 mit parallel zueinander ausgerichteten optischen Achsen 111 und relativ großen Überlappungsbereichen 13 der Kameras 11, die dem halben Bildwinkel 112 jeder Kamera 11 entsprechen. Dadurch wird eine lückenlose, annähernd linienförmige Abtastung über die volle Breite des Substrats 2 erreicht, sodass bei einem quer bewegten Substrat 2, wie in der rechts befindlichen Seitenansicht von Fig. 1 durch den Pfeil angedeutet, möglich ist, mit einer Abtastung alle entlang der Substratbreite befindlichen Zielmarken 22 ohne mechanische Kamerabewegung zu erfassen. Eine nahezu linienförmige Abtastung durch die Registriereinheit 1 wird dadurch realisiert, dass diese mit Kameras 11 in Form von Zeilenkameras ausgestattet ist. Um einen linienförmigen Abtastbereich quer zur Bewegungsrichtung des Substrats 2 zu erzeugen, müssen die entozentrischen Kameras 11 mit in einer Ebene (nicht gezeichnet) liegenden optischen Achsen 111 auf eine Abtastlinie 23 (nur in Fig. 2 eingezeichnet) auf die Substratfläche 21 derart gerichtet sein, dass ihre Bildwinkel 112 dort zur Überlappung kommen und entlang der Abtastlinie 23 die Überlappungsbereiche 13 bilden.

Bei üblichen Substratbreiten von 500-635 mm sind für die derzeit geforderte Auflösung (von 8-12 $\mu$m/Pixel auf dem Substrat 2) entozentrische Kameras 11 (in Form von Zeilenkameras) mit 330 mm Abtastlänge im Fokusbereich einsetzbar, sodass eine mit fünf Kameras 11 ausgestattete Registriereinheit 1 bei 165 mm Abstand der optischen Achsen 111 der Kameras 11 in Richtung der Substratbreite (Querausdehnung des Substrats 2) die gesamte Substratbreite vollständig überspannen kann, wobei jeder Ort der Abtastlinie 23 in zwei unterschiedlichen Kamerabildern benachbarter Kameras 11 simultan und redundant erfasst wird. Für dieses Beispiel ergibt sich mit den fünf auf die Abtastlinie 23 gerichteten Kameras 11 eine Gesamtabtastlänge von 660 mm, die zur Gewährleistung einer lückenlosen doppelten Abtastung auch im Falle von Positionier- oder Montagetoleranzen der Kameras 11 und/oder Höhenschwankungen $\Delta z$ des Substrats 2 weiter zusammengerückt werden können, weil die derzeit maximale Substratbreite (635 mm) um 25 mm überschritten ist und dadurch zusätzliche geringe Überlappungen 14 der Überlappungsbereiche 13 sowie jeweils ein sicheres Abtasten über die Randbereiche des Substrats 2 hinaus möglich sind.

Mit der beschriebenen Anordnung der Kameras 11 gemäß Fig. 1 lässt sich entlang der Abtastlinie 23 ein tatsächlich linienförmiger Abtastbereich abtasten, der ein Länge-zu-Breite-Verhältnis von mehr als 2.000 aufweist. Allgemein kann die Registriereinheit 1 eine Abtastlinie 23 mit einem Länge-zu-Breite-Verhältnis von mehreren 1.000 bis 100.000 aufweisen, wobei die Abtastbreite in Bewegungsrichtung y des Substrats 2 durch elektronische Steuerung (Synchronisation) der Auslesemodi und - geschwindigkeiten der Kameras 11 durch die Rechnereinheit 5 angepasst werden kann.

Die gemäß Fig. 1 mit zueinander parallelen optischen Achsen 111 angeordneten Kameras 11 sind entlang der Abtastlinie 23 (nur in Fig. 2, 4 und 6 eingezeichnet) so dicht zueinander angeordnet, dass benachbarte Kameras 11 miteinander einen Überlappungsbereich 13 von mindestens dem halben Bildwinkel 112 bilden und eine weitere lediglich geringe Überlappung 14 mit dem Bildwinkel 112 der übernächsten Kamera 11 vorhanden ist, wenn bei drei oder mehr Kameras 11 eine lückenlose Abdeckung der Substratoberfläche 21 mit den Überlappungsbereichen 13 auch bei Höhenschwankungen $\Delta z$ des Substrats 2 und mechanischen Justierungenauigkeiten garantiert werden soll.

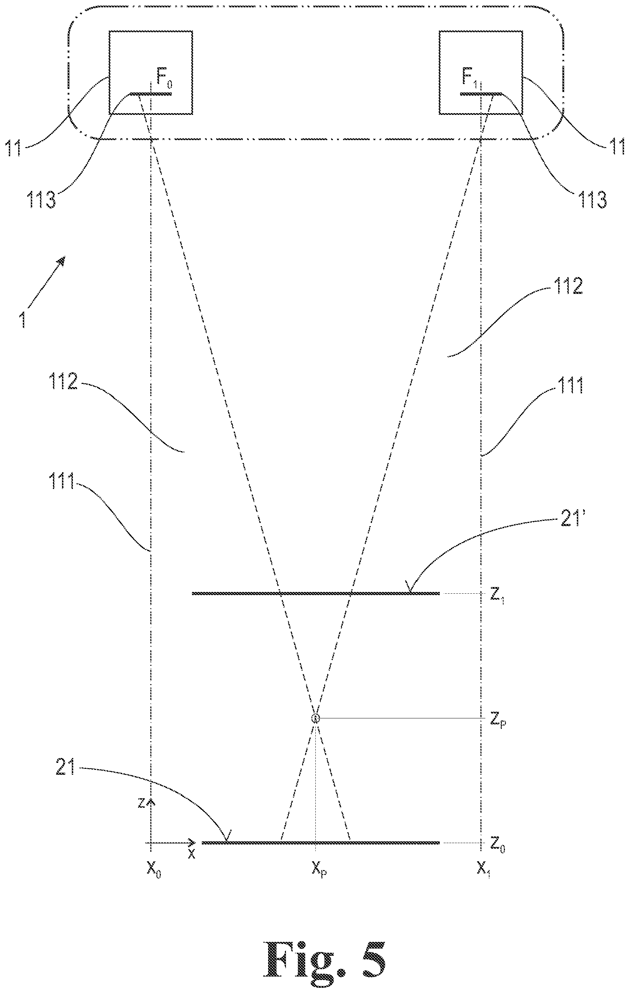

An den Rändern des Substrats 2 bzw. der durch die Kameras 11 gebildeten Abtastlinie 23 ist infolge der senkrecht zum Substrat 2 ausgerichteten optischen Achsen 111 der Kameras 11 nur der halbe Bildwinkel 112 nutzbar, damit auch im Randbereich des Substrats 2 stets ein Überlappungsbereich 13 vorhanden ist. Das ist deshalb erforderlich, da bei entozentrischen Kameras 11 die Ortsbestimmung einer auf dem Substrat 2 vorhandenen Zielmarke 22 - je weiter diese von der optischen Achse 111 beabstandet ist - in der Kameraabbildung sehr empfindlich vom Abstand der Substratoberfläche 21 zur Fokalebene $F_n$ (nur in Fig. 5 bezeichnet) der jeweiligen Kamera 11 abhängt. Zur Bestimmung des Abstandes einer auf der Oberfläche 21 des Substrats 2 beliebig positionierten Zielmarke 22 wird deshalb eine Triangulation aus zwei Kameraabbildungen benachbarter Kameras 11 entlang der Abtastlinie 23 durchgeführt und kann auch für jeden anderen Punkt der Abtastlinie 23 fortgesetzt werden, soweit - außer den Zielmarken 22 - auswertbare Strukturen auf dem Substrat 2 vorhanden sind.

In z-Richtung ist die exakte Ermittlung der Höhenschwankungen $\Delta z$ der Substratoberfläche 21 auf Bereiche mit erfassbaren Punkten (auswertbaren Strukturen) beschränkt, sodass das Höhenprofil des Substrats 2 gegebenenfalls durch interpolierte Werte ergänzt werden muss.

Die Triangulation des Abstandes der Substratoberfläche 21 ist entscheidend für die Bestimmung des Abtastortes einer Zielmarke 22, da jegliche Höhenschwankungen $\Delta z$ der Oberfläche 21 des Substrats 2 zu erheblichen Messfehlern bei der Bestimmung der x- und y-Koordinaten einer Zielmarke 22 führen können, je näher diese dem Rand des Bildwinkels 112 der Kamera 11 kommt.

Mit geringem Abstand vom Substrat 2 im Gehäuse 12 der Registriereinheit 1 positionierte und unter verschiedenen schrägen Einfallswinkeln angeordnete Lichtquellen 17 sind zur gezielten Beleuchtung der Abtastlinie 23, die durch die Auftreffpunkte der optischen Achsen 111 der Kameras 11 definiert wird, vorgesehen.

Wie bereits oben erwähnt, kann bei der Kameraanordnung nach Fig. 1 von den äußeren Kameras 11 jeweils eine Hälfte des Bildaufnahmebereiches (des Bildwinkels 112) nicht genutzt werden. Durch einen alternativen, auf einem Scheimpflug-Prinzip basierenden Systemaufbau, der in Fig. 2 gezeigt ist, können die obigen Nachteile vermieden und die Scanbereiche innerhalb des gesamten Bildwinkels 112 jeder der benachbarten, zueinander geneigten Kameras 11 optimal genutzt werden. Allerdings steigen die Anforderungen an die Objektive 15 und die Ausrichtung und Justierung der Kameras 11.

Während ein erstes lückenloses Registrierungsprinzip gemäß Fig. 1 für eine Gesamtdetektionsbreite von > 635 mm (> 25") mit fünf Kameras 11 ausgestattet ist, kann die gleiche Detektionsbreite der Registriereinheit 1 bei dem Anordnungsprinzip gemäß Fig. 2 durch nur vier Kameras 11 abgetastet werden.

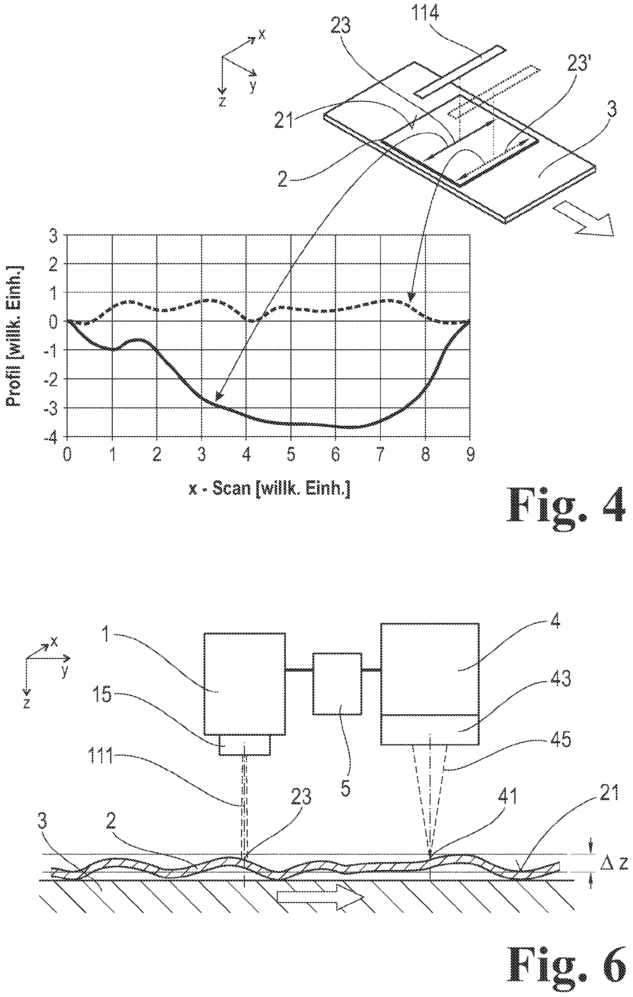

Die Detektionsbreite über alle Kameras 11 ist so bemessen, dass sie größer ist als der maximale Bearbeitungsbereich der Bearbeitungseinheit 4 (nur in Fig. 6 und Fig. 7 bezeichnet), d.h. als die maximale Länge des Bearbeitungspfades 41 auf dem Substrat 2, beispielsweise erzeugt durch einen mittels eines Polygonscanners gescannten Bearbeitungsstrahl 45 (nur in Fig. 6 und Fig. 7 gezeichnet).

Eine zweite Bedingung für die Anzahl und Anordnung der Kameras 11 ist die erforderliche objektseitige optische Auflösung, die in Abhängigkeit der zu erfassenden Zielmarkengröße häufig auf ca. 10 $\mu$m/Pixel festgelegt und in den vorgeschlagenen Beispielen mit ca. 11 $\mu$m/Pixel realisiert ist. Eine dritte Randbedingung betrifft die Abtastgeschwindigkeit, die auf den gewünschten Durchsatz von Leiterplatten auf eine Substratgeschwindigkeit von 1.000 mm/s bis 1.800 mm/s angepasst sein soll.

Als Kompromiss zwischen hoher Auslesegeschwindigkeit, Maximierung der Abtastbreite auf Basis großer Zeilenlänge und vertretbaren Preises der Sensorzeilen 114, werden für die Kameras 11 vornehmlich Zeilenkameras mit Sensorzeilen 114, die mehr als 3.000 Pixel und 11 $\mu$m x 11 $\mu$m Kantenlänge aufweisen, verwendet. Die Anpassung der erforderlichen Breite des Substrats 2 an die Auflösung der Zeilenkamera erfolgt mittels des Abbildungsmaßstabs der Objektive 15 der Kameras 11.

Fig. 2 zeigt im Unterschied zu Fig. 1 eine Konfiguration aus vier Kameras 11, die in einer einheitlichen Kameraebene entlang der Abtastlinie 23 gegeneinander geneigte optische Achsen 111 aufweisen, um für den gleichen Abtastbereich wie in Fig. 1 (635 mm) lückenlos die Registrierung der Zielmarken 22 vornehmen zu können. Dabei bilden zwei Kameras 11 ein Paar von unter Scheimpflug-Bedingung positionierten Kameras 11, die miteinander einen größeren Überlappungsbereich 13 ihrer Bildwinkel 112 aufweisen, der vorzugsweise einer vollständigen Überdeckung der Bildwinkel 112 der beiden Kameras 11 entspricht.

Ist das Substrat 2 nicht breiter als diese Abtastlinie 23 aus den Bildwinkeln 112 der zwei benachbarten Kameras 11, so kann man die Triangulation für jeden Substratpunkt entlang der Abtastlinie 23 aus den zwei Kameraabtastungen von nur zwei benachbarten, gegeneinander geneigten Kameras 11 berechnen. Andernfalls, wenn die Substratbreite größer ist, können weitere paarweise zueinander geneigte Kameras 11 entlang der gewünschten Abtastlinie 23 aneinandergereiht werden, bis die Überlappungsbereiche 13 der jeweils zwei Kameras 11 die volle Breite des Substrats 2 überdecken. Dabei müssen sich die Überlappungsbereiche 13 mindestens berühren, sollten aber wegen möglicher Höhenschwankungen $\Delta z$ des Substrats 2 und mechanischer Montage- bzw. Justagetoleranzen der Kameras 11 ebenfalls eine geringere Überlappung 14 aufweisen, die für eine maximale Höhenschwankungen $\Delta z$ und Montagetoleranzen der Kameras 11 stets die lückenlose Abtastung der Abtastlinie 23 auf dem Substrat 2 durch eine zusätzliche Überlappung 14 der durch vollständige Überlappung der Bildwinkel 112 gebildeten Überlappungsbereiche 13 der jeweiligen Paare von Kameras 11 sicherstellt. Der Vorteil dieser Kamerakonstellation nach Fig. 2 liegt darin, dass im einfachsten Fall genau zwei Kameras 11 unter Einhaltung der Scheimpflug-Bedingungen denselben Bereich der Abtastlinie 23 "sehen" und keine Teilbereiche der Bildwinkel 112 der Kameras 11 ungenutzt bleiben. Gegenüber Fig. 1 wird dadurch - bei gleicher Länge der Abtastlinie 23, d.h. bei gleicher Substratbreite, eine Kamera 11 eingespart.

Zugleich ist mit jedem unter Scheimpflug-Bedingungen angeordneten Paar von Kameras 11 eine zusätzliche Höhentriangulation zur Feststellung der Höhenabweichungen $\Delta z$ der Substratoberfläche 21 möglich, wenn im Überlappungsbereich 13 ausreichend viele Zielmarken 22 oder andere abtastbare Strukturen vorhanden sind.

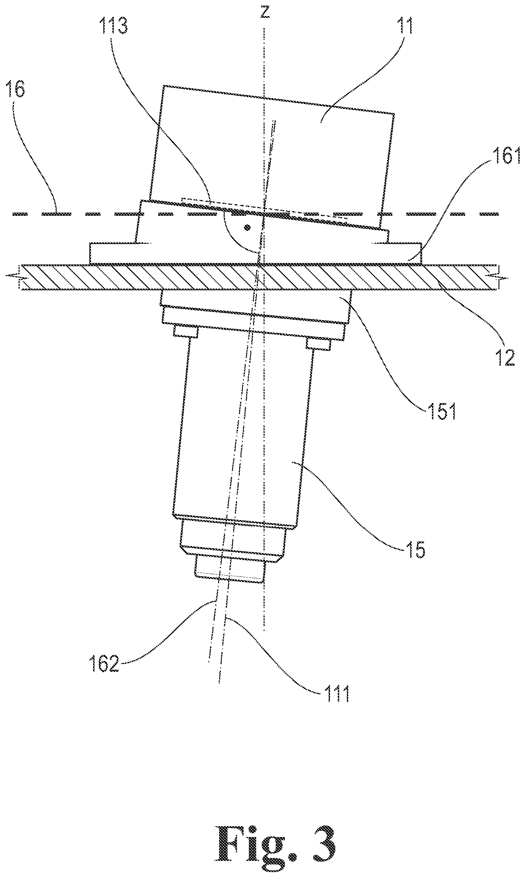

Fig. 3 stellt eine der zwei benachbarten, zueinander geneigten Kameras 11 dar, bei der die Abbildung von Objekt- und Bildebene entzerrt wird, indem unterschiedliche Neigungswinkel von Objektiv 15 und Sensorchip 113 (bzw. Neigung von Objektiv zu Kamera, wenn man letztere vom Objektiv 15 separat betrachtet) eingestellt sind und einer Scheimpflug-Bedingung genügen.

In Fig. 4 ist eine Sensorzeile 114 stellvertretend für eine Kamera 11 der Registriereinheit 1 schematisch dargestellt, um die Problematik einer schwankenden Höhe der Substratoberfläche 21 am Beispiel einer Substratwelligkeit aufzuzeigen. Die rechte obere Teildarstellung von Fig. 4 zeigt schematisch ein in y-Richtung bewegtes Tischsystem 3 auf dem ein Substrat 2 aufgelegt ist. Über dem Substrat 2 befindet sich die auf eine Sensorzeile 114 reduzierte Registriereinheit 1, die entlang der Abtastlinie 23 eine Registrierung von Zielmarken 22 (nur in Fig. 2 und Fig. 7 dargestellt) vornimmt. Für ein bezüglich Zielmarken 22 abzutastendes Substrat 2 wird angenommen bzw. ist bekannt, dass es entweder instabil ist oder wellig aufliegt, woraus Höhenschwankungen $\Delta z$ der Substratoberfläche 21 resultieren. Bei einer fortschreitenden Relativbewegung der Sensorzeile 114 in y-Richtung werden entlang der Abtastlinie 23 (in x-Richtung) unterschiedliche Höhenverläufe aufgenommen, die sich je nach Lage der Zielmarken 22 im Bildwinkel 112 der entozentrischen Kameras 11 genauigkeitsmindernd auf die x-y-Positionsbestimmung der Zielmarken 22 auswirken.

Infolge des Vorschubes des Tischsystems 3 tastet die Sensorzeile 114 zuerst die gepunktete Abtastlinie 23' ab mit dem Ergebnis der gestrichelten Profillinie im Diagramm darunter. Einige Ausleseschritte später erfasst die Sensorzeile 114 dann die durchgezogene Abtastlinie 23 und nimmt eine von der gestrichelten Profillinie deutlich abweichende durchgezogene Profillinie auf. Diese örtlich sehr unterschiedlichen Höhenschwankungen $\Delta z$ können bei der Bearbeitung durch die Bearbeitungseinheit 4 (nur in Fig. 6 gezeichnet) zu erheblichen Abweichungen der belichteten Strukturen führen, die durch Defokussierung (Verbreiterung) des Bearbeitungsstrahls 45 verursacht werden. Die Defokussierung kann nur dann durch Nachfokussierung behoben werden, wenn die Orte der Höhenschwankungen $\Delta z$ genau gemessen und die Fokussierung des Bearbeitungsstrahls 45 entlang einer den Positionen der Zielmarken 22 und den Höhenschwankungen $\Delta z$ angepassten Bearbeitungslinie 41 nachgeführt wird.

In Fig. 5 wird ein Beispiel für die Bestimmung der Höhenschwankungen $\Delta z$ der Substratoberfläche 21 des Substrats 2 mittels Triangulation dargestellt, bei der zwei benachbarte Kameras 11 parallele optische Achsen 111 und zwei in derselben Ebene liegende Fokalebenen $F_n$ und $F_{n+1}$ der Sensorchips 113 (hier für n =0 gezeigt) aufweisen und ein Überlappungsbereich 13 der Bildwinkel 112 (d.h. der linearen Abtastbereiche) zweier Kameras 11 auftritt. Das ist deshalb notwendig, da die detektierten Zielmarkenpositionen in der x-y-Ebene auf der Substratoberfläche 21 bei Abbildung mittels entozentrischer Objektive 15 empfindlich abhängig sind von der Objektlage in z-Richtung. Deshalb erfolgt die Erfassung der zu registrierenden Zielmarken 22 mit Kamerabildern eines Paares von benachbarten Kameras 11 und die Berechnung der Zielmarkenpositionen x, z nach einem Triangulationsverfahren, bei dem für die z-Richtung die Höhenschwankung auf zwei Bezugsebenen bezogen wird, die in der unteren Ebene als Substratoberfläche 21 und in der oberen Ebene zur Kennzeichnung der Oberflächenänderung mit Substratoberfläche 21' bezeichnet ist. Die resultierende x-Position und die resultierende Höhe z werden letztlich aus den in beiden Kameras 11 detektierten Positionen der verschiedenen Kalibrierwerte $z_1, z_0$ bezüglich der Kalibrierebenen der Substratoberflächen 21 und 21' wie folgt bestimmt.

$$x_p = \frac{x_{1r} x_{0s} - x_{1s} x_{0r}}{x_{1r} - x_{1s} + x_{0s} - x_{0r}}$$

$$z_p = \frac{x_{0s} - x_{1s}}{x_{1r} - x_{1s} + x_{0s} - x_{0r}} \cdot (z_1 - z_0)$$

Das bedeutet, dass neben der genauen Bestimmung der Zielmarkenposition in x auch die z-Position im Verhältnis zu den Kalibrierebenen $z_1, z_0$ bestimmt werden kann. Dadurch wird eine (absolute) Höhenmessung möglich.

In Fig. 6 ist eine Seitenansicht der Registriereinheit 1 analog zur rechten Schnittdarstellung von Fig. 1 gezeigt. und die Verknüpfung der ermittelten Positionsdaten von Zielmarken 22 (nur in Fig. 2 und Fig. 7 gezeichnet) über eine Rechnereinheit 5 mit der Bearbeitungseinheit 4 schematisch dargestellt. Die Problematik eines unebenen Substrats 2 ist stilisiert und vergrößert für eine wellige Substratoberfläche 21 gezeichnet, wobei das Tischsystem 3 als Präzisionstisch angenommen wurde.

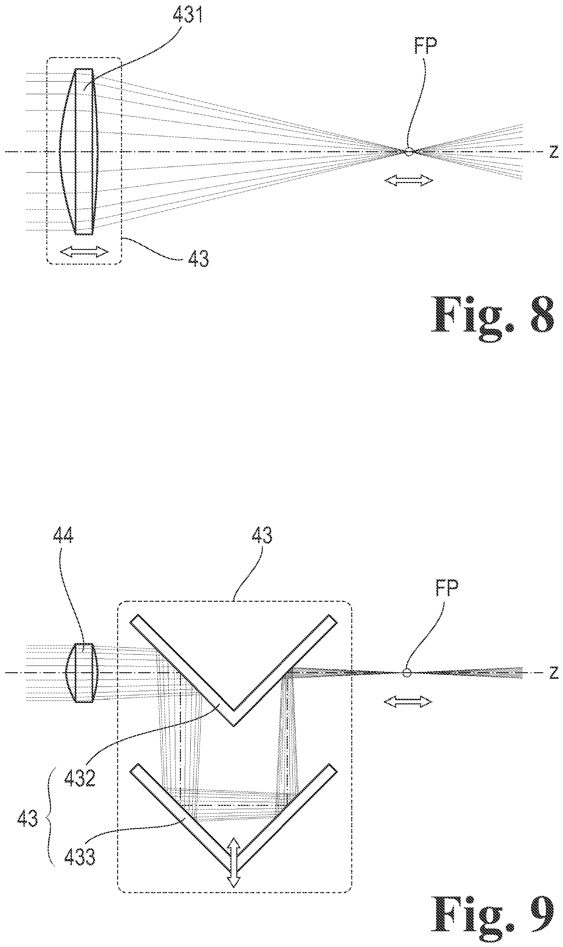

Bei Bewegung des Tischsystems 3 in y-Richtung erfasst die Registriereinheit 1 auf dem Substrat 2 in einem linearen Abtastbereich (Abtastlinie 23, die durch mehrere Zeilenkameras orthogonal zur Zeichnungsebene gebildet wird) durch sukzessive Zeilenabtastungen die x- und y-Positionen von beliebig auf dem Substrat 2 angeordneten Zielmarken 22. Aufgrund der von den Kameras 11 gebildeten Überlappungsbereiche 13 der Bildwinkel 112 (nur in Fig. 1 und Fig. 2 sichtbar) wird infolge einer Doppelabtastung jedes Substratpunktes durch zwei benachbarte Kameras 11 sichergestellt, dass mittels Triangulation nicht nur die exakten Zielmarkenpositionen ermittelt, sondern auch die Höhenschwankungen $\Delta z$ der Substratoberfläche 21 berechnet werden können. Aus den Messwerten der realen Substrathöhe z in jedem durch abgebildete Strukturen erfassbaren Punkt der Abtastlinie 23 wird dann in der Rechnereinheit 5 neben der üblichen Ausrichtung der zweidimensionalen Struktur des Bearbeitungsmusters gegenüber der realen Position der Zielmarken 22 zusätzlich der Bearbeitungsfokus FP (nur in Fig. 8 und 9 gezeichnet) des Bearbeitungsstrahls 45 entlang des Bearbeitungspfades 41 mittels Fokusnachführung 43 an die Höhenschwankungen $\Delta z$ der Substratoberfläche 21 punktuell angepasst.

In der in Fig. 7 dargestellten beispielhaften Ausführung der Erfindung ist das Substrat 2 ein Endlossubstrat, das von Rolle zu Rolle (nicht dargestellt) über ein Rollentischsystem 31 straff geführt wird. Das Rollentischsystem 31 kann einen Trommeldurchmesser zwischen 200 und 500 mm aufweisen.

Aufgrund der straffen Materialführung des endlosen Substrats 2 kann die Abtastlinie 23 (in Fig. 7 nicht sichtbar) der Kameras 11 der Registriereinheit 1 vor der Kontaktlinie des Substrats 2 mit dem Rollentischsystem 31 angeordnet sein.

Dabei ist die Registriereinheit 1 mit zwei entozentrischen Kameras 11 so ausgestaltet, dass die Abtastbereiche der zwei Kameras 11 eine Abtastlinie 23 (nicht sichtbar) bilden, die noch über die Ränder des Substrats 2 hinausgeht, um Kalibriermarken 32 auf dem Rollentischsystem 31 mit erfassen zu können. Zur Notwendigkeit und Handhabung der Kalibriermarken 32 wird auf die nicht vorveröffentlichte DE 10 2019 128 198.9 verwiesen.

Ansonsten detektiert die Registriereinheit 1, wie für ebene Substrate 2 zu Fig. 1 und 2 beschrieben, alle auf dem mit dem Rollentischsystem 31 vorbeigeführten Substrat 2 befindlichen Zielmarken 22, unabhängig davon, an welcher Stelle sich diese auf dem Substrat 2 befinden.

Wegen der Besonderheit, dass das Substrat 2 als Endlossubstrat straff gespannt auf dem Rollentischsystem 31 geführt wird und somit keine - durch Welligkeit des Substrats 2 verursachten - Höhenschwankungen $\Delta z$ aufweist, kann bei dieser Ausführungsform der Erfindung auf eine lokale Punkt-für-Punkt-Höhenmessung verzichtet und die Höhenmessung der Substratoberfläche 21 auf einen kleinen Überlappungsbereich 13 der Bildwinkel 112 der beiden Kameras 11 beschränkt werden. Im Überlappungsbereich 13, der in diesem Fall sehr viel kleiner als der halbe Bildwinkel 112 der beiden Kameras 11 sein kann, mindestens aber 1/50 (>5 mm) des Erfassungsbereiches der Registriereinheit 1 (d.h. Substratbreite zuzüglich Randbereiche des Rollentischsystems 31), vorzugsweise zwischen 1/40 und 1/10, besonders bevorzugt von 1/35 bis 1/25 (ca. 10-15 mm), wird - in Analogie zur Beschreibung von Fig. 5 - eine Triangulationsrechnung durchgeführt, aus der in diesem Beispiel die Dicke des Substrats 2 und gegebenenfalls Dickenschwankungen über die Gesamtlänge des Endlossubstrats ermittelt werden können. Eine schnelle Fokusänderung entlang des Bearbeitungspfades 41 mittels der Fokusnachführung 43, wie zu Fig. 6 beschrieben, ist aber in der Regel nicht erforderlich. Dennoch ist die Dickeninformation, d.h. der z-Messwert als Höhe der Substratoberfläche 21, zur Berechnung der Positionen der Zielmarken 22 in x- und y-Richtung unbedingt erforderlich. Sie kann aber nach anfänglicher einmaliger Ermittlung (und gegebenenfalls von Zeit zu Zeit wiederholter Einzelmessung) für die Berechnungen der Positionen aller Zielmarken 22 des gesamten Endlossubstrats beibehalten werden. Die Bearbeitungseinheit 4, die in einer anderen Radialebene des Rollentischsystems 31 auf die Substratoberfläche 21 ausgerichtet ist, sendet einen gescannten Bearbeitungsstrahl 45 zur Einprägung von zweidimensionalen Strukturen auf den Bearbeitungspfad 41 der Substratoberfläche 21. Sie kann aber auch in einer gemeinsamen Ebene (z.B. Axialebene des Rollentischsystems 31) diametral entgegengesetzt zur Registriereinheit 1 am Rollentischsystem 31 angeordnet sein (nicht gezeichnet).

Für die mit den Unebenheiten des Substrats 2 bzw. der Substratoberfläche 21 entstehenden Höhenschwankungen $\Delta z$, wie sie zu Fig. 4 und 6 beschrieben wurden, ist erfindungsgemäß eine schnelle punktuelle Fokusnachführung 43 für den Bearbeitungsstrahl 45 entlang des linearen Bearbeitungspfades 41 erforderlich, sodass letzterer zu einer höhenveränderlichen Bearbeitungslinie entartet.

Für diese schellen Fokusänderungen in z-Richtung des in x-Richtung gescannten Bearbeitungsstrahles 45, der für photolithographische Direktbelichtungsverfahren ein Laserstrahl ist, sind herkömmliche Autofokussysteme ungeeignet. Die Grundlage für die erfindungsgemäß schnelle Umsetzung einer lokalen Fokusänderung über den Bearbeitungspfad 41 liegt in der Erfassung der Höhenschwankungen $\Delta z$ des Substrats 2 bereits simultan mit der Registrierung der Zielmarken 22 durch die redundante zweifache Bildaufnahme mittels entozentrischer Kameras 11 mit lückenlosen Überlappungsbereichen 13 ihrer Bildwinkel 112 entlang eines linienförmigen Abtastbereichs (Abtastlinie 23). Durch diese zeitlich und örtlich der Bearbeitungseinheit 4 vorgelagerte, durch Triangulationsberechnungen erfolgte Höhenmessung für jeden Bildpunkt der Abtastlinie 23 ist mittels der Rechnereinheit 5 außer der bereits üblichen Anpassung der in Bearbeitungspfade 41 zerlegten Daten von zweidimensionalen Strukturmustern an die durch die detektierten Zielmarken 22 erfasste Lage des Substrats 2 zusätzlich eine punktuelle Änderung des Bearbeitungsfokus FP entlang des Bearbeitungspfades 41 des Bearbeitungsstrahls 45 berechenbar in Abhängigkeit von den entlang der Abtastlinie 23 der Registriereinheit 1 erfassten und in der Rechnereinheit 5 berechneten Höhenschwankungen $\Delta z$.

Für die schnellen Fokusänderungen entlang des Bearbeitungspfades 41 sind zusätzliche Mittel zur Ergänzung der sonst üblichen Fokussieroptik 44 erforderlich. Diese müssen eine solche Qualität haben, dass sie die Scanfrequenz des Bearbeitungsstrahls 45 in der Querrichtung x zur Bewegungsrichtung y des Substrats 2 um mindestens das Doppelte übertreffen. Vorzugweise liegt die Frequenz der Fokusänderung zwischen dem Zweifachen und dem Dreißigfachen, insbesondere bevorzugt zwischen dem Fünffachen und dem Zwanzigfachen, der Scanfrequenz des Bearbeitungsstrahls 45, die bei Verwendung eines Polygonscanners im Bereich zwischen 0,5 und 1 kHz liegt.

Fig. 8 zeigt dazu eine erste Möglichkeit für die Realisierung der Fokusnachführung 43 mittels einer beweglichen Linse 431.

Eine weitere Ausführungsvariante der Fokusnachführung 43 gemäß Fig. 9 sieht einen festen Winkelspiegel 432 und einen beweglichen Retroreflektor 433 vor, wobei der im bereits fokussierten Bündel angeordnete Winkelspiegel 432 das fokussierte Bündel auf den Retroreflektor 433 auskoppelt und nach dessen Reflexion wieder einkoppelt und der Retroreflektor 433 sich zum Winkelspiegel 432 hin- oder vom Winkelspiegel 432 wegbewegt, um den Fokus FP in z-Richtung zu verschieben.

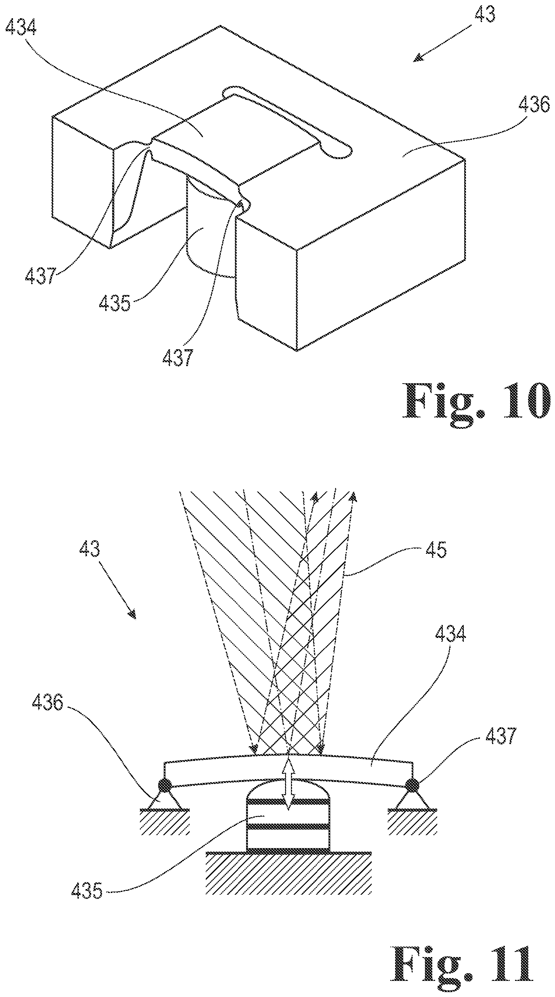

Eine weitere spiegelbasierte Ausführung der Fokusnachführung 43 wird in den Fig. 10 bis 12 beschrieben. Dazu zeigen Fig. 10 und 11 eine Spiegelbaugruppe mit einem Spiegel mit veränderlicher Krümmung, der im Folgenden als elastisch biegbarer Spiegel 434 bezeichnet wird. Dazu ist in Fig. 11 das Wirkprinzip als mechanisches Ersatzschaltbild dargestellt, bei dem der biegbare Spiegel 434 im Randbereich beweglich angelenkt an einer Spiegelhalterung 436 eines Basiskörpers befestigt ist und im Zentralbereich mit einem linearen Aktuator in Form eines Piezostapels 435 in Kontakt steht, der sich am gleichen Basiskörper wie die Spiegelhalterung 436 abstützt. Fig. 10 zeigt die körperliche Umsetzung der Spiegelbaugruppe als nahezu monolithisches Bauteil, bei dem die Spiegelhalterung 436 als Rechteckquaderkörper den elastisch biegbaren Spiegel 434 als monolithisch ausgedünntes, vorgewölbtes Metallplättchen trägt, das an zwei parallelen linearen Festkörperlagern elastisch gelagert ist. Dadurch ist der biegbare Spiegel 434 ein konvexer oder konkaver Zylinderspiegel, der lediglich in einer Raumrichtung seine Krümmung ändern kann.

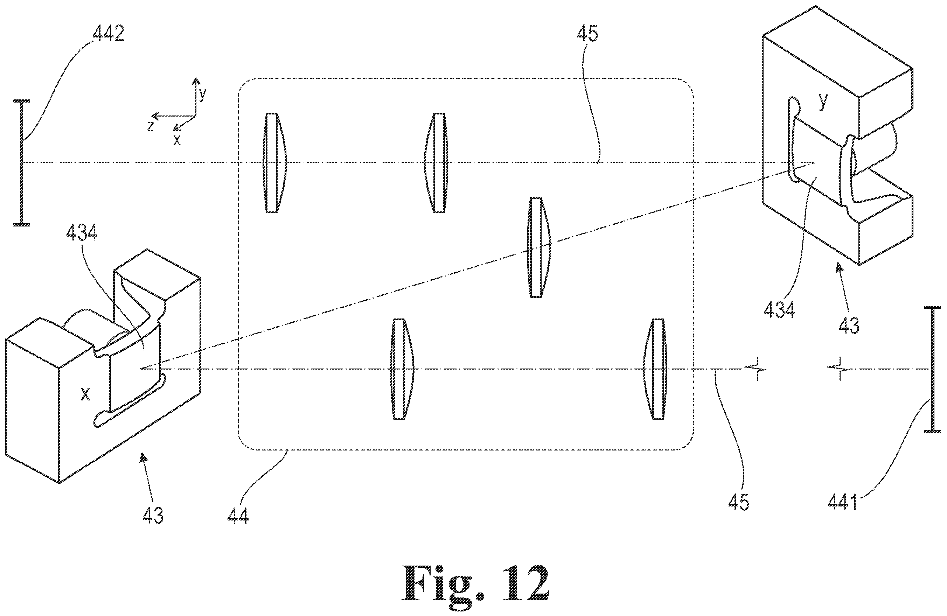

Gemäß der Ausführung von Fig. 12 sind zur Fokussteuerung zwei gekreuzt, z.B. in x und y-Richtung, ausgerichtete elastisch biegbare Spiegel 434 in einem gefalteten Strahlengang einer mehrgliedrigen Fokussieroptik 44 für den Bearbeitungsstrahl 45 (nur in Fig. 7 und Fig. 8 gezeichnet) angeordnet. In diesem Fall ist die schnelle Fokusnachführung 43 in die übliche Fokussieroptik 44 integriert, wobei die Zwischenbildebene 441 die punktuelle Erzeugung der örtlich an die Position der Zielmarken 22 angepassten, zur Bearbeitung vorgegebenen zweidimensionalen Struktur (nicht gezeichnet) vorgibt, die in der Bildebene 442 auf den vorteilhaft verwendeten Polygonscanner (nicht gezeichnet) zur Führung des Bearbeitungsstrahls 45 entlang der höhengesteuerten Bearbeitungslinie 41 auf das Substrat 2 übertragen wird. Ein Vorteil dieser Ausgestaltung der schnellen Fokussteuerung mit zwei eindimensional wirksamen Fokusnachführungen 43 besteht darin, dass in x-Richtung (Scanrichtung des Bearbeitungsstrahls 45) und y-Richtung (Substratbewegungsrichtung) mit unterschiedlichen Fokussierungen gearbeitet werden kann. Somit können in Scan- und Cross-Scan-Richtung des Bearbeitungsstrahls 45 (falls nötig) unterschiedliche Fokusänderungen bei astigmatischen oder anderen asphärischen Optiken bedient werden.

Mit der Erfindung ist es möglich, durch Einsatz von entozentrischen Kameras 11 zur Zielmarkenregistrierung eine lückenlose und annähernd eindimensionale Abtastlinie 23 auf Substraten 2 mit Höhenänderungen oder Krümmungen zu realisieren, die nicht nur eine Erfassung der Zielmarken 22, sondern auch eine Messung der Höhe und Höhenschwankung $\Delta z$ des Substrats 2 gestattet. Auf Basis einer Doppelabtastung mit zwei unterschiedlich positionierten Kameras 11 entlang der Abtastlinie 23 der Registriereinheit 1 können mittels entozentrischer Zeilenkameras, deren Bildwinkel 112 sich überlappen, in den Überlappungsbereichen 13 Triangulationsmessungen und -berechnungen erfolgen, die eine Höhenmessung gestatten. Durch punktuelle Höhenmessungen können Höhenschwankungen $\Delta z$ der Substratoberfläche 21 in der ebenfalls mit linienförmigem Bearbeitungspfad 41 betriebenen Bearbeitungseinheit 4 durch eine schnelle Fokussteuerung berücksichtigt werden, und bei der Steuerung des Bearbeitungsstrahls 45 mittels einer Fokusnachführung 43 korrigiert bzw. punktuell entlang des Bearbeitungspfades 41 zu einer höhenadaptierten Bearbeitungslinie werden.

Zusätzlich ermöglicht die dynamische Fokusanpassung entlang des Bearbeitungspfades 41 zugleich auch eine Korrektur bekannter (aus dem Optikdesign und der Optikfertigung resultierender) abbildungsbedingter Fokusabweichungen des über den Bearbeitungspfad 41 gescannten Bearbeitungsstrahls 45.

Bezugszeichen

| 1 | Registriereinheit |
|---|---|
| 11 | Kamera |
| 111 | optische Achse |
| 112 | Bildwinkel |
| 113 | Sensorchip |
| 114 | Sensorzeile |
| 12 | Gehäuse (der Registriereinheit) |
| 13 | Überlappungsbereich (der Bildwinkel) |
| 14 | geringfügige Überlappung (von Bildwinkeln) |
| 15 | Objektiv (der Kamera 11) |
| 151 | Objektivadapter |
| 16 | Bildebene (der Registriereinheit 1) |
| 161 | Kameraadapter |

162    Flächennormale (des Sensorchips 113)
17     Lichtquellen (zur Beleuchtung des linearen Abtastbereichs)

2      Substrat
21, 21'    Substratoberfläche
22     Zielmarke (Target)
23, 23'    Abtastlinie

3      Tischsystem
31     Rollentischsystem (für Endlossubstrat)
32     Kalibriermarke

4      Bearbeitungseinheit
41     Bearbeitungspfad
43     Fokusnachführung
431    bewegliche Linse
432    (fester) Winkelspiegel
433    (beweglicher) Retroreflektor
434    (elastisch) biegbarer Spiegel
435    Piezostapel (Linearaktuator)
436    Spiegelhalterung
437    Festkörpergelenk
44     Fokussieroptik
441    Zwischenbild
442    Bildebene

5      Rechnereinheit

$F_n$, $F_{n+1}$    Fokalebene
FP     Fokus (nachgeführt)
x      Querrichtung (in der Breite des Substrats 2)
y      Bewegungsrichtung (in der Länge des Substrats 2)
z      Fokussierrichtung (in der Höhe des Substrats 2)
$\Delta z$     Höhenschwankung (des Substratoberfläche 21)

**Patentansprüche**

1. Vorrichtung zur Belichtungssteuerung bei photolithographischer Direktbelichtung von zweidimensionalen Strukturen in photoempfindlichen Beschichtungen auf einem Substrat, enthaltend eine Registriereinheit zum Registrieren von auf einer Substratoberfläche befindlichen Zielmarken, ein bewegliches Tischsystem zur Auflage und definierten eindimensionalen Bewegung des Substrats unterhalb der Registriereinheit, eine Bearbeitungseinheit mit einem steuerbaren linearen Bearbeitungspfad zur photolithographischen Bearbeitung des Substrats mittels eines Bearbeitungsstrahls zur Einprägung der zweidimensionalen Strukturen sowie eine Rechnereinheit zur Steuerung der Ausrichtung zwischen Bearbeitungspfad und Substrat mittels örtlicher Anpassung der photolithographischen Bearbeitung in Abhängigkeit von der durch registrierte Zielmarken ermittelten Lage des Substrats, **dadurch gekennzeichnet, dass**

- in der Registriereinheit (1) mehrere entozentrische Kameras (11) zur Ausbildung eines lückenlosen linearen Abtastbereichs (23) über eine vorgegebene Breite des Substrats (2) in linearer Ausrichtung quer zur eindimensionalen Bewegung des Substrats (2) angeordnet sind und in Richtung des linearen Abtastbereichs (23) ausgedehnte Bildwinkel (112) aufweisen, wobei die Bildwinkel (112) benachbarter entozentrischer Kameras (11) entlang des linearen Abtastbereichs (23) einen Überlappungsbereich (13) haben, um im Überlappungsbereich (13) redundante Bildaufnahmen des Substrats (2) der benachbarten Kameras (11) zu erfassen, und
- die Rechnereinheit (5) Mittel zur Berechnung der Position der Zielmarken (22) aus den redundanten Bildaufnahmen im Überlappungsbereich (13) der benachbarten entozentrischen Kameras (11) unter zusätzlicher Verwendung einer durch Triangulation eines Abstandes der Substratoberfläche (21) ermittelten Höhenposition der Zielmarken (22) aufweist.

2. Vorrichtung nach Anspruch 1, **dadurch gekennzeichnet, dass**
die Registriereinheit (1) mit einer Mehrzahl von entozentrischen Kameras (11) zur Erzeugung des linear durchgehenden lückenlosen Sensorbereichs derart ausgestattet ist, dass Bildwinkel (112) von benachbarten Kameras (11) einen Überlappungsbereich (13) aufweisen, der mindestens so groß wie der halbe Bildwinkel (112) ist, wobei die Rechnereinheit (5) derart eingerichtet ist, um beliebig über die Breite des Substrats (2) positionierte Zielmarken (22) unabhängig von der Position der Zielmarke (22) innerhalb von lückenlos aufeinanderfolgenden Überlappungsbereichen (13) der Bildwinkel (112) von jeweils benachbarten entozentrischen Kamera (11) durch Triangulation eines Abstandes an beliebigen Positionen der Substratoberfläche (21) zu ermitteln.

3. Vorrichtung nach Anspruch 1 oder 2, **dadurch gekennzeichnet, dass** die Kameras (11) Zeilenkameras sind, um den linienförmigen Abtastbereich (23) durch Kameras (11) mit großer Abtastlänge schmal, lückenlos und mit Überlappungsbereichen über die gesamte Breite des Substrats (2) auszubilden.

4. Vorrichtung nach einem der Ansprüche 1 bis 3, **dadurch gekennzeichnet, dass** die Kameras (11) mit zueinander parallelen optischen Achsen (111) auf die Substratoberfläche (21) gerichtet sind, wobei die Überlappungsbereiche (13) der Bildwinkel (112) aller Kameras (11) gleich groß sind.

5. Vorrichtung nach einem der Ansprüche 1 bis 4, **dadurch gekennzeichnet, dass** zwei benachbarte Kameras (11) mit zueinander geneigten optischen Achsen (111) auf die Substratoberfläche (21) gerichtet sind, wobei der Überlappungsbereich (13) der Bildwinkel (112) der zueinander geneigten Kameras (11) so eingestellt ist, dass die Bildwinkel (112) der zwei Kameras (11) auf der Substratoberfläche (21) vollständig überlappen, wobei wahlweise der Überlappungsbereich (13), der durch paarweise zueinander geneigte Kameras (11) gebildet ist, mindestens an einen weiteren Überlappungsbereich (13) lückenlos angeschlossen ist, bis die Überlappungsbereiche (13) eine Ausdehnung aufweisen, die mindestens der Breite des Substrats (2) entspricht, wobei zwischen Paaren von zueinander geneigten Kameras (11) eine Überlappung (14) vorgesehen sein kann, um für alle zulässigen Höhenschwankungen (Az) der Substratoberfläche (21) einen lückenlosen Abtastbereich (23) der Registriereinheit (1) zu garantieren.

6. Vorrichtung nach Anspruch 5, **dadurch gekennzeichnet, dass** die paarweise mit zueinander geneigten Kameras (11) so angeordnet sind, dass sie einer Scheimpflug-Bedingung unterliegen.

7. Vorrichtung nach einem der Ansprüche 1 bis 6, **dadurch gekennzeichnet, dass** die Rechnereinheit (5) zusätzlich eine Steuerung für eine schnelle Fokusnachführung (43) der Bearbeitungseinheit (4) entlang des Bearbeitungspfades (41) in Abhängigkeit von Höhenschwankungen (Az) der Substratoberfläche (21) aufweist, die eine Triangulation von Zielmarken (22) oder beliebigen abgebildeten Strukturen der Substratoberfläche (21) auf Basis der redundanten Bildaufnahmen im Überlappungsbereich (13) der benachbarten entozentrischen Kameras (11) beinhaltet.

8. Vorrichtung nach einem der Ansprüche 1 bis 7, **dadurch gekennzeichnet, dass** die Registriereinheit (1) für die Zielmarkenerfassung lediglich zwei auf einer Abtastlinie (23) quer zur Bewegungsrichtung des Substrats (2) angeordnete entozentrische Kameras (11) mit einem Überlappungsbereich (13) von einem Hundertstel bis einem Drittel des Bildwinkels (112) der Kamera (11) aufweist, wenn das Substrat (2) als flexibles Endlossubstrat auf einem Rollentischsystem (31) straff und ohne Höhenschwankungen (Az) geführt ist, wobei der Überlappungsbereich (13) der Bildwinkel (112) der zwei Kameras (11) so ausgelegt ist, dass die Triangulation zum Zwecke der genauen Ermittlung der Dicke des Substrats (2) im Überlappungsbereich (13) der Bildwinkel (112) auf dem Rollentischsystem (31) anwendbar ist und für die gesamte Breite des Rollentischsystems (31) als konstant angenommen werden kann.

9. Vorrichtung nach einem der Ansprüche 1 bis 8, **dadurch gekennzeichnet, dass** die Registriereinheit (1) mit Lichtquellen (17) zur Beleuchtung des linearen lückenlosen Abtastbereichs ausgestattet ist, die im Gehäuse (12) gleichmäßig verteilt zur Realisierung einer durch Dunkelfeld- oder Hellfeldbeleuchtung homogen beleuchteten Abtastlinie (23) angeordnet sind,

wobei wahlweise die Lichtquellen (17) für eine ständige Beleuchtung eingerichtet sind und über eine Einrichtung zur Steuerung von mindestens einer Eigenschaft aus Helligkeit, Einfallswinkel oder Spektralbereich verfügt, oder wobei wahlweise die Lichtquellen (17) für eine ständige Beleuchtung eingerichtet sind, um Bildaufnahmen durch Steuerung der Integrationszeit der Sensorzeile (114) mittels eines elektronischen Shutter-Prinzips zu ermöglichen.

10. Vorrichtung nach einem der Ansprüche 1 bis 9, **dadurch gekennzeichnet, dass** eine Fokusnachführung (43) für Höhenschwankungen (Az) des Substrats (2) in die Bearbeitungseinheit (4) integriert ist, mit der von der Rechnereinheit (5) mittels Triangulation aus mit zwei benachbarten Kameras (11) der Registriereinheit (1) redundant aufgenommen Bildern ermittelte Höhenschwankungen (Az) durch schnelle Fokuskorrektur je Bildpunkt der Registriereinheit (1) in Echtzeit anpassbar sind, wobei die Fokusnachführung (43) auf Basis von Änderungen einer Linsenoder Spiegelposition oder -Wölbung steuerbar ist.

11. Vorrichtung nach Anspruch 10, **dadurch gekennzeichnet, dass** die Fokusnachführung (43) auf Basis der Änderung einer Spiegelwölbung mindestens in Querrichtung x zur Bewegungsrichtung y des Substrats (2) steuerbar ist.

12. Vorrichtung nach Anspruch 11, **dadurch gekennzeichnet, dass** die Fokusnachführung (43) auf Basis von Änderungen einer Spiegelwölbung in Bewegungsrichtung y des Substrats (2) und einer Spiegelwölbung in Querrichtung x separat steuerbar ist.

13. Vorrichtung nach einem der Ansprüche 10 bis 12, **dadurch gekennzeichnet, dass** die Fokusnachführung (43) durch Änderung der Spiegelwölbung mittels eines Piezoelements (435) steuerbar ist,
wobei, wahlweise, die Fokusnachführung (43) auf Basis von Änderungen einer Linsen- oder Spiegelposition oder -Wölbung ebenfalls zur Korrektur von aus dem Optikdesign oder der Optikfertigung resultierender abbildungsbedingter Fokusabweichungen einer vorgelagerten Fokussieroptik (44) oder anderer vorgelagerter optischer Elemente anwendbar ist.

14. Verfahren zur Belichtungssteuerung bei photolithographischen Direktbelichtung von zweidimensionalen Strukturen in photoempfindlichen Beschichtungen auf einem Substrat, mit den folgenden Schritten:

- Anordnen mehrerer entozentrischer Kameras (11) zu einem lückenlosen linearen Abtastbereich (23) quer zu einer Bewegungsrichtung des Substrats (2) in einer Registriereinheit (1) zum Erfassen von auf dem Substrat (2) befindlichen Zielmarken (22), wobei die entozentrischen Kameras (11) entlang des linearen Abtastbereichs (23) ausgedehnte Bildwinkel (112) mit einem von benachbarten entozentrischen Kameras (11) gebildeten Überlappungsbereich (13) aufweisen, um im Überlappungsbereich (13) redundante Bildaufnahmen des Substrats (2) aus benachbarten Kameras (11) zu erhalten,
- Bewegen des Substrats (2) auf einem beweglichen Tischsystem (3) in einer definierten eindimensionalen Bewegung unterhalb der Registriereinheit (1) hindurch,
- Bereitstellen einer Bearbeitungseinheit (4) zur photolithographischen Erzeugung der zweidimensionalen Strukturen mit einem Bearbeitungsstrahl (45), der entlang eines linearen Bearbeitungspfades (41) steuerbar ist,
- Erfassen der räumlichen Lage von beliebig über eine vorgegebene Breite des Substrats (2) verteilten Zielmarken (22) bezüglich Längen-, Breiten- und einer Höhenposition bei einem einzigen Durchlauf des Substrats (2) durch den linearen Abtastbereich (23) der Registriereinheit (1),
- Ermitteln der Positionen der beliebig über die Breite des Substrats (2) verteilten Zielmarken (22) aus den redundanten Bildaufnahmen im Überlappungsbereich (13) der benachbarten entozentrischen Kameras (11) unter zusätzlicher Verwendung einer durch Triangulation eines Abstandes der Substratoberfläche (21) aus den redundanten Bildaufnahmen benachbarter entozentrischer Kameras (11) ermittelten Höhenposition der Zielmarken (22),
- Berechnen von Daten zur Ausrichtung und örtlichen Anpassung der Bearbeitung des Substrats (2) mit zweidimensionalen Strukturen für die Bearbeitungseinheit (4) zur Steuerung des Bearbeitungsstrahls (45) entlang des quer zur Bewegungsrichtung des Substrats (2) ausgerichteten, linearen Bearbeitungspfades (41), und
- Steuern der Ausrichtung zwischen Bearbeitungspfad (41) und Substrat (2) und örtliche Anpassung der photolithographischen Bearbeitung in Abhängigkeit von der durch registrierte Zielmarken (22) ermittelten Lage des Substrats (2).

15. Verfahren nach Anspruch 14, wobei das Berechnen der räumlichen Lage von beliebig über die Breite des Substrats (2) verteilten Zielmarken (22) auf Basis einer Höhenposition bei einem Durchlauf des Substrats (2) auf die Triangulation weiterer erfassbarer Strukturen des Substrats (2) in den im Überlappungsbereich (13) aufgenommenen redundanten Bildern erweitert wird, und eine schnelle Fokusanpassung des Fokus (FP) des Bearbeitungsstrahles (45) mittels einer Fokusnachführung (43) entlang eines Bearbeitungspfades (41) auf Basis einer Steuerung einer Linsen- oder Spiegelposition oder einer Spiegelwölbung erfolgt, wobei wahlweise die schnelle Fokusanpassung des Fokus (FP) des Bearbeitungsstrahles (45) mit einer mindestens zweifach bis dreißigfach höheren Frequenz als die herkömmliche Scanfrequenz für den Bearbeitungsstrahl (45) erfolgt.

**Claims**

1. A device for exposure control during photolithographic direct exposure of two-dimensional structures in photosensitive coatings on a substrate, comprising a registration unit for registering target marks located on a substrate surface, a movable table system for supporting and defined one-dimensional movement of the substrate below the registration unit, a processing unit with a controllable linear processing path for photolithographic processing of the substrate by means of a processing beam for imprinting the two-dimensional structures, and a computer unit for controlling the alignment between the processing path and the substrate by means of local adaptation of the photolithographic processing depending on the position of the substrate determined by registered target marks, **characterized in that**

   - in the registration unit (1), a plurality of entocentric cameras (11) are arranged in a linear alignment transverse to the one-dimensional movement of the substrate (2) to form an uninterrupted linear scanning region (23) across a predetermined width of the substrate (2) and have extended view angles (112) in the direction of the linear scanning region (23), wherein the view angles (112) of adjacent entocentric cameras (11) along the linear scanning region (23) have an overlap region (13) in order to capture redundant images of the substrate (2) of the adjacent cameras (11) in the overlap region (13), and
   - the computer unit (5) has means for calculating the position of the target marks (22) from the redundant image recordings in the overlapping region (13) of the adjacent entocentric cameras (11) by additionally using a vertical position of the target marks (22) determined by triangulation of a distance of the substrate surface (21).

2. The device according to claim 1, **characterized in that**
   the registration unit (1) is equipped with a plurality of entocentric cameras (11) for generating the linearly continuous, uninterrupted sensor region such that view angles (112) of adjacent cameras (11) have an overlap region (13) which is at least as large as half the view angle (112), wherein the computer unit (5) is set up in such a way as to determine target marks (22) positioned arbitrarily across the width of the substrate (2) independently of the position of the target mark (22) within seamlessly successive overlap regions (13) of the view angles (112) of respectively adjacent entocentric cameras (11) by triangulating a distance at arbitrary positions on the substrate surface (21).

3. The device according to claim 1 or 2, **characterized in that** the cameras (11) are line cameras in order to form the linear scanning region (23) by cameras (11) with a long scanning length, in a narrow, uninterrupted manner and with overlapping regions over the entire width of the substrate (2).

4. The device according to any one of claims 1 to 3, **characterized in that** the cameras (11) are directed onto the substrate surface (21) with mutually parallel optical axes (111), wherein the overlap regions (13) of the view angles (112) of all cameras (11) are of the same size.

5. The device according to any one of claims 1 to 4, **characterized in that** two adjacent cameras (11) are directed onto the substrate surface (21) with mutually inclined optical axes (111), wherein the overlap region (13) of the view angles (112) of the mutually inclined cameras (11) is set such that the view angles (112) of the two cameras (11) completely overlap on the substrate surface (21),
   wherein optionally the overlap region (13), which is formed by pairs of mutually inclined cameras (11), is connected without interruptions to at least one further overlap region (13) until the overlap regions (13) have an extent which corresponds at least to the width of the substrate (2), wherein an overlap (14) can be provided between pairs of mutually inclined cameras (11) in order to ensure a gap-free scanning region (23) of the registration unit (1) for all permissible height fluctuations (Az) of the substrate surface (21).

6. The device according to claim 5, **characterized in that** the pairs of mutually inclined cameras (11) are arranged so that they are subject to a Scheimpflug condition.

7. The device according to any one of claims 1 to 6, **characterized in that** the computer unit (5) additionally has a control for rapid focus tracking (43) of the processing unit (4) along the processing path (41) as a function of height fluctuations (Az) of the substrate surface (21), which includes triangulation of target marks (22) or any imaged structures of the substrate surface (21) on the basis of the redundant image recordings in the overlapping region (13) of the adjacent entocentric cameras (11).

8. The device according to any one of claims 1 to 7, **characterized in that** the registration unit (1) for target mark detection has only two entocentric cameras (11) arranged on a scanning line (23) transversely to the direction of movement of the substrate (2) with an overlap region (13) of one hundredth to one third of the view angle (112) of the camera (11) when the substrate (2) is guided as a flexible endless substrate on a roller table system (31) tight and without height fluctuations (Az), wherein the overlap region (13) of the view angles (112) of the two cameras (11) is designed such that the triangulation for the purpose of precisely determining the thickness of the substrate (2) in the overlap region (13) of the view angles (112) on the roller table system (31) can be used and can be assumed to be constant for the entire width of the roller table system (31).

9. The device according to any one of claims 1 to 8, **characterized in that** the registration unit (1) is equipped with light sources (17) for illuminating the linear, uninterrupted scanning region, which are arranged uniformly distributed in the housing (12) to realize a scanning line (23) homogeneously illuminated by dark field or bright field illumination,

> wherein optionally the light sources (17) are configured for continuous illumination and have a device for controlling at least one property of brightness, angle of incidence or spectral range,
> or wherein optionally the light sources (17) are arranged for continuous illumination in order to enable image recording by controlling the integration time of the sensor line (114) by means of an electronic shutter principle.

10. The device according to any one of claims 1 to 9, **characterized in that** a focus tracking (43) for height fluctuations (Az) of the substrate (2) is integrated into the processing unit (4), with which height fluctuations (Az) determined by the computer unit (5) by means of triangulation from images redundantly recorded with two adjacent cameras (11) of the registration unit (1) can be adapted in real time by rapid focus correction for each pixel of the registration unit (1), wherein the focus tracking (43) can be controlled on the basis of changes in a lens or mirror position or curvature.

11. The device according to claim 10, **characterized in that** the focus tracking (43) is controllable on the basis of the change in a mirror curvature at least in the transverse direction x relative to the direction of movement y of the substrate (2).

12. The device according to claim 11, **characterized in that** the focus tracking (43) is separately controllable on the basis of changes in a mirror curvature in the direction of movement y of the substrate (2) and a mirror curvature in the transverse direction x.

13. The device according to any one of claims 10 to 12, **characterized in that** the focus tracking (43) can be controlled by changing the mirror curvature by means of a piezoelectric element (435),
wherein, optionally, the focus tracking (43) based on changes in a lens or mirror position or curvature can also be used to correct imaging-related focus deviations of an upstream focusing optics (44) or other upstream optical elements resulting from the optics design or optics manufacture.

14. A method for exposure control in photolithographic direct exposure of two-dimensional structures in photosensitive coatings on a substrate, comprising the following steps:

> - arranging a plurality of entocentric cameras (11) to form an uninterrupted linear scanning region (23) transversely to a direction of movement of the substrate (2) in a registration unit (1) for detecting target marks (22) located on the substrate (2), wherein the entocentric cameras (11) have extended view angles (112) along the linear scanning region (23) with an overlap region (13) formed by adjacent entocentric cameras (11) in order to obtain redundant image recordings of the substrate (2) from adjacent cameras (11) in the overlap region (13),
> - moving the substrate (2) on a movable table system (3) in a defined one-dimensional movement below the registration unit (1),
> - providing a processing unit (4) for photolithographically producing the two-dimensional structures with a processing beam (45) which is controllable along a linear processing path (41),
> - detecting the spatial position of target marks (22) distributed arbitrarily over a predetermined width of the substrate (2) with respect to length, width and a height position during a single pass of the substrate (2) through the linear scanning region (23) of the registration unit (1),
> - determining the positions of the target marks (22) distributed arbitrarily across the width of the substrate (2) from the redundant image recordings in the overlapping region (13) of the adjacent entocentric cameras (11) with additional use of a height position of the target marks (22) determined by triangulation of a distance of the substrate surface (21) from the redundant image recordings of adjacent entocentric cameras (11),
> - calculating data for the alignment and local adjustment of the processing of the substrate (2) with two-dimensional structures for the processing unit (4) for controlling the processing beam (45) along the linear processing path (41) aligned transversely to the direction of movement of the substrate (2), and
> - controlling the alignment between the processing path (41) and the substrate (2) and locally adapting the photolithographic processing depending on the position of the substrate (2) determined by registered target marks (22).

15. The method according to claim 14, wherein the calculation of the spatial position of target marks (22) distributed arbitrarily across the width of the substrate (2) on the basis of a height position during a pass of the substrate (2) is extended to the triangulation of further detectable structures of the substrate (2) in the redundant images recorded in the overlap region (13), and a rapid focus adjustment of the focus (FP) of the processing beam (45) is carried out by means of a focus tracking (43) along a processing path (41) on the basis of a control of a lens or mirror position or a mirror curvature, wherein optionally the rapid focus adjustment of the focus (FP) of the processing beam (45) is carried out at a frequency at least two to thirty times higher than the conventional scanning frequency for the processing beam (45).

**Revendications**

1. Dispositif de commande d'exposition lors de l'exposition directe photolithographique de structures bidimensionnelles dans des revêtements photosensibles sur un substrat, comprenant une unité d'enregistrement pour enregistrer des repères cibles situés à la surface du substrat, un système de table mobile pour supporter et définir le mouvement unidimensionnel du substrat sous l'unité d'enregistrement, une unité de traitement avec un trajet de traitement linéaire contrôlable pour le traitement photolithographique du substrat au moyen d'un faisceau de traitement pour l'impression des structures bidimensionnelles, et une unité informatique pour commander l'alignement entre le trajet de traitement et le substrat par réglage local du traitement photolithographique en fonction de la position du substrat déterminée par les repères cibles enregistrés, **caractérisé en ce que**

   - dans l'unité d'enregistrement (1), plusieurs caméras entocentriques (11) sont disposées selon un alignement linéaire transversal au mouvement unidimensionnel du substrat (2) pour former une zone de balayage linéaire sans espace (23) sur une largeur prédéterminée du substrat (2) et présentent des angles d'image (112) étendus dans la direction de la zone de balayage linéaire (23), dans lequel les angles d'image (112) des caméras entocentriques adjacentes (11) le long de la zone de balayage linéaire (23) présentent une zone de chevauchement (13) afin de capturer des prises de vue redondantes du substrat (2) des caméras adjacentes (11) dans la zone de chevauchement (13), et
   - l'unité informatique (5) comporte des moyens pour calculer la position des repères cibles (22) à partir des prises de vue redondantes dans la zone de chevauchement (13) des caméras entocentriques adjacentes (11) avec utilisation supplémentaire d'une position en hauteur des repères cibles (22) déterminée par triangulation d'une distance de la surface du substrat (21).

2. Dispositif selon la revendication 1, **caractérisé en ce que** l'unité d'enregistrement (1) est équipée d'une pluralité de caméras entocentriques (11) pour générer la zone de capteur linéairement continue et sans espace de telle sorte que les angles d'image (112) des caméras adjacentes (11) aient une zone de chevauchement (13) qui est au moins aussi grande que la moitié de l'angle d'image (112), dans lequel l'unité informatique (5) est configurée de manière à déterminer des repères cibles (22) positionnés arbitrairement sur la largeur du substrat (2) indépendamment de la position du repère cible (22) dans des zones de chevauchement successives sans espace (13) des angles d'image (112) des caméras entocentriques (11) respectivement adjacentes par triangulation d'une distance à des positions arbitraires sur la surface du substrat (21).

3. Dispositif selon la revendication 1 ou 2, **caractérisé en ce que** les caméras (11) sont des caméras linéaires afin de former la zone de balayage linéaire (23) par des caméras (11) avec une longueur de balayage longue et étroite, sans espace et avec des zones de chevauchement sur toute la largeur du substrat (2).

4. Dispositif selon l'une des revendications 1 à 3, **caractérisé en ce que** les caméras (11) sont dirigées sur la surface du substrat (21) avec des axes optiques (111) parallèles entre eux, dans lequel les zones de chevauchement (13) des angles d'image (112) de toutes les caméras (11) sont de même taille.

5. Dispositif selon l'une des revendications 1 à 4, **caractérisé en ce que** deux caméras adjacentes (11) sont dirigées vers la surface du substrat (21) avec des axes optiques (111) inclinés l'un vers l'autre, dans lequel la zone de chevauchement (13) des angles d'image (112) des caméras (11) inclinées l'une vers l'autre est réglée de telle sorte que les angles d'image (112) des deux caméras (11) se chevauchent complètement sur la surface du substrat (21), dans lequel la zone de chevauchement (13), qui est formée par des paires de caméras (11) inclinées les unes vers les autres, est reliée éventuellement sans espace à au moins une autre zone de chevauchement (13) jusqu'à ce que les zones de chevauchement (13) aient une étendue qui correspond au moins à la largeur du substrat (2), dans lequel un chevauchement (14) peut être prévu entre des paires de caméras (11) inclinées l'une vers l'autre afin de garantir une zone de balayage (23) sans espace de l'unité d'enregistrement (1) pour toutes les fluctuations de hauteur (Az) admissibles de la surface du substrat (21).

6. Dispositif selon la revendication 5, **caractérisé en ce que** les caméras (11) inclinées par paires les unes vers les autres sont disposées de manière à être soumises à une condition de Scheimpflug.

7. Dispositif selon l'une des revendications 1 à 6, **caractérisé en ce que** l'unité informatique (5) comporte également une commande pour le suivi rapide de la mise au point (43) de l'unité de traitement (4) le long du trajet de traitement (41) en fonction des fluctuations de hauteur (Az) de la surface du substrat (21), qui comprend la triangulation de repères cibles (22) ou de structures arbitraires imagées de la surface du substrat (21) à partir des prises de vue redondantes dans la zone de chevauchement (13) des caméras entocentriques adjacentes (11).

8. Dispositif selon l'une des revendications 1 à 7, **caractérisé en ce que** l'unité d'enregistrement (1) pour la détection de repères cibles ne comporte que deux caméras entocentriques (11) disposées sur une ligne de balayage (23) transversalement à la direction de déplacement du substrat (2) avec une zone de chevauchement (13) d'un centième à un tiers de l'angle d'image (112) de la caméra (11) lorsque le substrat (2) est guidé comme substrat sans fin flexible sur un système de table à rouleaux (31) tendu et sans fluctuations de hauteur (Az), dans lequel la zone de chevauchement (13) des angles d'image (112) des deux caméras (11) est conçue de telle sorte que la triangulation pour la détermination précise de l'épaisseur du substrat (2) dans la zone de chevauchement (13) des angles d'image (112) sur le système de table à rouleaux (31) puisse être utilisée et puisse être considérée comme constante sur toute la largeur du système de table à rouleaux (31).

9. Dispositif selon l'une des revendications 1 à 8, **caractérisé en ce que** l'unité d'enregistrement (1) est équipée de sources lumineuses (17) pour éclairer la zone de balayage linéaire et sans espace, qui sont disposées uniformément dans le boîtier (12) pour réaliser une ligne de balayage (23) éclairée de manière homogène par un éclairage en fond sombre ou en fond clair,

dans lequel les sources lumineuses (17) sont agencées éventuellement pour un éclairage continu et comportent un dispositif permettant de commander au moins une propriété de luminosité, d'angle d'incidence ou de plage spectrale,
ou dans lequel les sources lumineuses (17) sont agencées éventuellement pour un éclairage continu afin d'effectuer des prises de vue en commandant le temps d'intégration de la ligne de capteurs (114) au moyen d'un principe d'obturateur électronique.

10. Dispositif selon l'une des revendications 1 à 9, **caractérisé en ce qu'**un suivi de mise au point (43) pour les fluctuations de hauteur (Az) du substrat (2) est intégré dans l'unité de traitement (4), avec lequel les fluctuations de hauteur (Az) déterminées par l'unité informatique (5) au moyen d'une triangulation à partir d'images enregistrées de manière redondante avec deux caméras adjacentes (11) de l'unité d'enregistrement (1) peuvent être adaptées en temps réel par correction rapide de la mise au point pour chaque pixel de l'unité d'enregistrement (1), dans lequel le suivi de mise au point (43) peut être commandé à partir de modifications de la position ou de la courbure d'une lentille ou d'un miroir.

11. Dispositif selon la revendication 10, **caractérisé en ce que** le suivi de mise au point (43) peut être commandé à partir de la modification d'une courbure de miroir au moins dans la direction transversale x à la direction de déplacement y du substrat (2).

12. Dispositif selon la revendication 11, **caractérisé en ce que** le suivi de mise au point (43) peut être commandé séparément à partir de modifications d'une courbure de miroir dans la direction de déplacement y du substrat (2) et d'une courbure de miroir dans la direction transversale x.

13. Dispositif selon l'une des revendications 10 à 12, **caractérisé en ce que** le suivi de mise au point (43) peut être commandé en modifiant la courbure de miroir au moyen d'un élément piézoélectrique (435),
dans lequel, éventuellement, le suivi de mise au point (43) basé sur des changements dans la position ou la courbure d'une lentille ou d'un miroir peut également être utilisé pour corriger les écarts de mise au point liés à l'imagerie d'une optique de mise au point en amont (44) ou d'autres éléments optiques en amont résultant de la conception ou de la fabrication de l'optique.

14. Procédé de commande d'exposition lors de l'exposition directe photolithographique de structures bidimensionnelles dans des revêtements photosensibles sur un substrat, comprenant les étapes suivantes :

- l'agencement d'une pluralité de caméras entocentriques (11) pour former une zone de balayage linéaire sans espace (23) transversalement à une direction de mouvement du substrat (2) dans une unité d'enregistrement (1) afin de détecter des repères cibles (22) situés sur le substrat (2), dans lequel les caméras entocentriques (11) ont des angles d'image étendus (112) le long de la zone de balayage linéaire (23) avec une zone de chevauchement (13) formée par des caméras entocentriques adjacentes (11) afin d'obtenir des prises de vue redondantes du substrat (2) à partir de caméras adjacentes (11) dans la zone de chevauchement (13),
- le déplacement du substrat (2) sur un système de table mobile (3) dans un mouvement unidimensionnel défini sous l'unité d'enregistrement (1),
- la fourniture d'une unité de traitement (4) pour produire par photolithographie les structures bidimensionnelles avec un faisceau de traitement (45) qui peut être commandé le long d'un trajet de traitement linéaire (41),
- la détection de la position spatiale de repères cibles (22) répartis arbitrairement sur une largeur prédéterminée du substrat (2) par rapport à la longueur, à la largeur et à une position en hauteur lors d'un seul passage du substrat (2) à travers la zone de balayage linéaire (23) de l'unité d'enregistrement (1),
- la détermination des positions des repères cibles (22) répartis arbitrairement sur la largeur du substrat (2) à partir des prises de vue redondantes dans la zone de chevauchement (13) des caméras entocentriques adjacentes (11) avec utilisation supplémentaire d'une position en hauteur des repères cibles (22) déterminée par triangulation d'une distance de la surface du substrat (21) à partir des prises de vue redondantes des caméras entocentriques adjacentes (11),
- le calcul des données pour l'alignement et la réglage local du traitement du substrat (2) avec des structures bidimensionnelles pour l'unité de traitement (4) afin de commander le faisceau de traitement (45) le long du trajet de traitement linéaire (41) aligné transversalement à la direction de déplacement du substrat (2), et
- la commande de l'alignement entre le trajet de traitement (41) et le substrat (2) et le réglage local du traitement photolithographique en fonction de la position du substrat (2) déterminée par des repères cibles (22) enregistrés.

15. Procédé selon la revendication 14, dans lequel le calcul de la position spatiale de repères cibles (22) répartis arbitrairement sur la largeur du substrat (2) à partir d'une position en hauteur lors d'un passage à travers le substrat (2) est étendu à la triangulation d'autres structures détectables du substrat (2) dans les images redondantes enregistrées dans la zone de chevauchement (13), et un réglage rapide de la mise au point (FP) du faisceau de traitement (45) est effectué au moyen d'un suivi de mise au point (43) le long d'un trajet de traitement (41) à partir d'une commande d'une position de lentille ou de miroir ou d'une courbure de miroir, dans lequel le réglage rapide de la mise au point (FP) du faisceau de traitement (45) est éventuellement effectué à une fréquence au moins deux à trente fois supérieure à la fréquence de balayage conventionnelle du faisceau de traitement (45).

# Fig. 1

# Fig. 2

**Fig. 3**

Fig. 4

Fig. 6

# Fig. 5

**Fig. 7**

Fig. 8

Fig. 9

**Fig. 10**

**Fig. 11**

Fig. 12

**IN DER BESCHREIBUNG AUFGEFÜHRTE DOKUMENTE**

**In der Beschreibung aufgeführte Patentdokumente**

- EP 0951054 A1
- EP 0722123 B1
- US 6806945 B2
- JP 2010181519 A
- WO 2016115536 A2
- EP 0954768 B1
- WO 03094582 A2
- DE 102018132001 A1

- EP 2775349 A1
- US 6245585 B1
- US 6449029 B1
- DE 102019128198
- US 20040223129 A1
- DE 102017102320 A1
- US 2007242317 A1
- US 2012327215 A1